# EUROPEAN PATENT APPLICATION

(11) **EP 4 586 785 A2**
(43) Date of publication of application: **16.07.2025**
(21) Application number: 24219929.7
(22) Date of filing: 13.12.2024
(51) Int. Cl.: H10K 59/131, H10K 59/88

(54) **DISPLAY DEVICE**

(30) Priority: 21.12.2023 KR 20230188712
(71) Applicant: Samsung Display Co., Ltd., Yongin-si, Gyeonggi-do 17113 (KR)
(72) Inventor: SHIN, Dong Hee, 17113 Yongin-si (KR); SON, Sun Kwun, 17113 Yongin-si (KR)
(74) Representative: Taor, Simon Edward William

(57) **Abstract**

A display device includes: a substrate; a first conductive layer, a second conductive layer, a third conductive layer, a fourth conductive layer, and a fifth conductive layer sequentially stacked on the substrate; a transistor on the substrate; a conductive pattern on the transistor, and electrically connected to the transistor, and comprising the third conductive layer; an insulating layer on the conductive pattern and including a first via hole exposing one area of the conductive pattern; a light emitting element on the insulating layer, and electrically connected to the conductive pattern through the first via hole; and a connection pattern between the conductive pattern and the light emitting element, and comprising the fourth conductive layer, wherein the connection pattern does not overlap the first via hole.

## Description

### CROSS-REFERENCE TO RELATED APPLICATION

The present application claims priority to and the benefit of Korean Patent Application Number 10-2023-0188712, filed on December 21, 2023, in the Korean Intellectual Property Office.

### BACKGROUND

### 1. Field

Aspects of some embodiments of the present disclosure relate to a display device.

### 2. Description of Related Art

Recently, as interest in information display increases, research and development on display devices have been continuously conducted.

The above information disclosed in this Background section is only for enhancement of understanding of the background and therefore the information discussed in this Background section does not necessarily constitute prior art.

### SUMMARY

Various embodiments of the present disclosure may provide a display device having relatively improved reliability.

Aspects of some embodiments of the present disclosure include a display device including: a substrate; a first conductive layer, a second conductive layer, a third conductive layer, a fourth conductive layer, and a fifth conductive layer sequentially stacked on the substrate; a transistor on the substrate; a conductive pattern on the transistor, and electrically connected to the transistor, and configured of the third conductive layer; an insulating layer on the conductive pattern and including a first via hole exposing one area of the conductive pattern; a light emitting element provided on the insulating layer, and electrically connected to the conductive pattern through the first via hole; and a connection pattern positioned between the conductive pattern and the light emitting element, and configured of the fourth conductive layer. According to some embodiments, the connection pattern may not overlap the first via hole.

According to some embodiments, the insulating layer may include a first passivation layer, a first via layer, a second passivation layer, and a second via layer that are sequentially on the conductive pattern. According to some embodiments, the connection pattern may be positioned between the first via layer and the second passivation layer. According to some embodiments, the light emitting element may be electrically connected to the conductive pattern through the first via hole of each of the first passivation layer, the first via layer, the second passivation layer, and the second via layer.

According to some embodiments, the connection pattern includes an opening area corresponding to the first via hole.

According to some embodiments, the connection pattern may include a first connection pattern extending in a first direction, and a second connection pattern extending in a second direction intersecting with the first direction. According to some embodiments, the first connection pattern and the second electrode pattern may form a mesh structure.

According to some embodiments, the light emitting element may include: a first electrode on the connection pattern, and electrically connected to the conductive pattern through the first via hole, and configured of the fifth conductive layer; an emission layer on the first electrode; and a second electrode on the emission layer. According to some embodiments, the connection pattern may be electrically connected with the second electrode.

According to some embodiments, in a sectional view, the first electrode may be positioned on the conductive pattern with the first via hole interposed therebetween, and the fourth conductive layer may not be positioned between the conductive pattern and the first electrode.

According to some embodiments, the display device may further include a dummy electrode configured of the fifth conductive layer, and spaced apart from the first electrode. According to some embodiments, the dummy electrode may be electrically connected to the connection pattern.

According to some embodiments, each of the second passivation layer and the second via layer may include a second via hole exposing a portion of the connection pattern. According to some embodiments, the dummy electrode may be electrically connected to the connection pattern through the second via hole.

According to some embodiments, the dummy electrode may include a first dummy electrode extending in a first direction, and a second dummy electrode extending in a second direction intersecting with the first direction. According to some embodiments, the first dummy electrode and the second dummy electrode may form a mesh structure.

According to some embodiments, the dummy electrode may include a first dummy electrode extending in a first direction, and a second dummy electrode extending in a second direction intersecting with the first direction. According to some embodiments, the first dummy electrode and the second dummy electrode may be spaced apart from each other.

According to some embodiments, the display device may further include a pixel defining layer on the first electrode, and including a first opening corresponding to the emission layer, and a second opening exposing one area of the dummy electrode. According to some embodiments, the second electrode may be electrically connected to the dummy electrode through the second opening.

According to some embodiments, the display device may further include a pixel defining layer on the first electrode, and including a first opening corresponding to the emission layer, and a second opening exposing one area of the second via layer. According to some embodiments, each of the second passivation layer and the second via layer may include a third via hole exposing one area of the connection pattern. According to some embodiments, the second electrode may be electrically connected to the connection pattern through the second opening and the third via hole.

According to some embodiments, the second opening and the third via hole may overlap each other, in a plan view.

According to some embodiments, the display device may further include a dummy electrode configured of the fifth conductive layer, and spaced apart from the first electrode. According to some embodiments, the dummy electrode may not be electrically connected to the connection pattern and the second electrode.

According to some embodiments, the display device may further include an encapsulation layer on the light emitting element.

According to some embodiments of the present disclosure a display device includes: a substrate; a transistor on the substrate; a conductive pattern on the transistor, and electrically connected to the transistor; a first insulating layer on the conductive pattern; a connection pattern on the first insulating layer; a second insulating layer on the connection pattern; a light emitting element including a first electrode on the second insulating layer, an emission layer on the first electrode, and a second electrode on the emission layer; and a dummy electrode on the second insulating layer, and spaced apart from the first electrode. According to some embodiments, the first electrode may be electrically connected to the conductive pattern through a first via hole passing through the first and the second insulating layers. According to some embodiments, the dummy electrode may be electrically connected to the connection pattern through a second via hole passing through the second insulating layer. According to some embodiments, the first via hole and the second via hole may not overlap each other.

According to some embodiments, the connection pattern may not overlap the first via hole.

According to some embodiments, the connection pattern may include an opening area corresponding to the first via hole.

According to some embodiments, the connection pattern may include a first connection pattern extending in the first direction, and a second connection pattern extending in a second direction intersecting with the first direction. According to some embodiments, the first connection pattern and the second electrode pattern may form a mesh structure.

According to some embodiments, the dummy electrode may include a first dummy electrode extending in a first direction, and a second dummy electrode extending in a second direction intersecting with the first direction. According to some embodiments, the first dummy electrode and the second dummy electrode may form a mesh structure.

According to an aspect, there is provided a display device as set out in claim 1. Additional features are set out in claims 2 to 12. According to an aspect, there is provided a display device as set out in claim 13. Additional features are set out in claims 14 and 15.

### BRIEF DESCRIPTION OF THE DRAWINGS

FIG. 1 is a schematic plan view illustrating a display device according to some embodiments.
FIG. 2 is a schematic cross-sectional view illustrating a display panel of FIG. 1.
FIG. 3 is a schematic plan view illustrating aspects of the pixels of FIG. 1 according to some embodiments.
FIG. 4 is a schematic circuit diagram illustrating an electrical connection relationship of components included in each of the pixels illustrated in FIG. 1.
FIG. 5 and FIG. 6 are schematic plan views illustrating a pixel according to some embodiments.
FIG. 7 is a schematic plan view illustrating only components included in a first conductive layer in the pixel of FIG. 6.
FIG. 8 is a schematic plan view illustrating transistors and only components included in a second conductive layer in the pixel of FIG. 6.
FIG. 9 is a schematic plan view illustrating only components included in a third conductive layer in the pixel of FIG. 6.
FIG. 10 is a schematic plan view illustrating only components included in a fourth conductive layer in the pixel of FIG. 6.
FIG. 11 is a schematic plan view illustrating only components included in a fifth conductive layer in the pixel of FIG. 6.
FIG. 12 is a schematic plan view illustrating an emission layer and a pixel defining layer in the pixel of FIG. 6.
FIG. 13 is a schematic cross-sectional view taken along the line I-I' of FIG. 6.
FIG. 14 and FIG. 15 are schematic cross-sectional views taken along the line II-II' of FIG. 6.
FIG. 16 is a schematic cross-sectional view taken along the line III-III' of FIG. 6.
FIG. 17 is a schematic plan view illustrating a pixel according to some embodiments.
FIG. 18 is a schematic plan view illustrating only components included in a fourth conductive layer in the pixel of FIG. 17.
FIG. 19 is a schematic plan view illustrating a pixel according to some embodiments.
FIG. 20 is a schematic plan view illustrating only components included in a fourth conductive layer in the pixel of FIG. 19.
FIG. 21 is a schematic plan view illustrating only components included in a fifth conductive layer in the pixel of FIG. 19.
FIG. 22 is a schematic plan view illustrating a pixel according to some embodiments.
FIG. 23 is a schematic cross-sectional view taken along the line IV-IV' of FIG. 22.

### DETAILED DESCRIPTION

As the present disclosure allows for various changes and numerous embodiments, particular embodiments will be illustrated in the drawings and described in detail in the written description. However, this is not intended to limit the present disclosure to particular modes of practice, and it is to be appreciated that all changes, equivalents, and substitutes that do not depart from the technical scope of the present disclosure are encompassed in the present disclosure.

Throughout the disclosure, like reference numerals refer to like parts throughout the various figures and embodiments of the present disclosure. The sizes of elements in the accompanying drawings may be exaggerated for clarity of illustration. It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, in case that a first part such as a layer, a film, a region, or a plate is located on a second part, the first part may be not only directly on the second part but a third part may intervene between them. In addition, in case that it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

It will be understood that when an element (e.g., a first element) is referred to as being (operatively or communicatively) "coupled with/to," or "connected with/to" another element (e.g., a second element), the first element can be coupled or connected with/to the second element directly or via another element (e.g., a third element). In contrast, it will be understood that when an element (e.g., a first element) is referred to as being "directly coupled with/to" or "directly connected with/to" another element (e.g., a second element), no other element (e.g., a third element) intervenes between the element and the other element.

Aspects of some embodiments of the present disclosure are described with reference to the accompanying drawings in order to describe embodiments according to the present disclosure in more detail so that those having ordinary knowledge in the technical field to which the present disclosure pertains can more easily practice embodiments according to the present disclosure. Furthermore, a singular form may include a plural form as long as it is not specifically mentioned in a sentence.

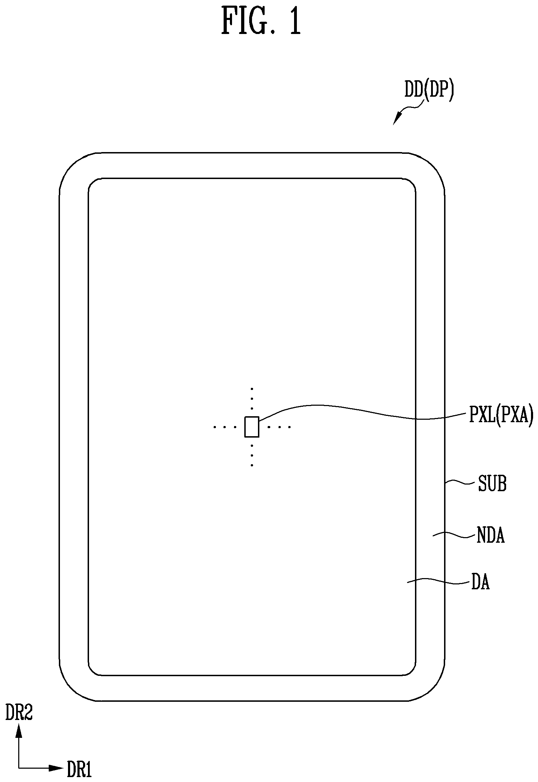

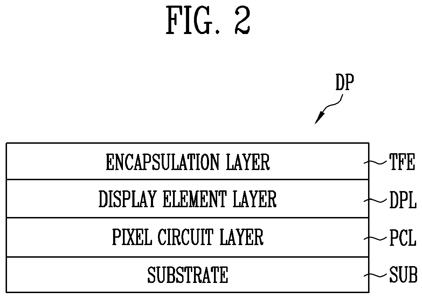

FIG. 1 is a schematic plan view illustrating a display device DD according to some embodiments. FIG. 2 is a schematic cross-sectional view illustrating a display panel DP of FIG. 1.

In FIGS. 1 and 2, for the convenience sake, there is schematically illustrated the display device DD, for example, the structure of the display panel DP provided in the display device DD, centered on a display area DA in which images are displayed.

Referring to FIGS. 1 and 2, for the convenience sake, there is schematically illustrated the display device DD, for example, the structure of the display panel DP provided in the display device DD, centered on a display area DA in which images are displayed.

Referring to FIGS. 1 and 2, the display panel DP (or the display device DD) according to some embodiments may be provided in various shapes. For example, the display panel DP may be provided in the form of a rectangular plate having two pairs of sides parallel to each other (e.g., with relatively long sides and relatively short sides). However, embodiments are not limited to the aforementioned example. In the case where the display panel DP is provided in the form of a rectangular plate, one pair of sides of the two pairs of sides may be longer than the other.

At least a portion of the display panel DP may have flexibility, and the display panel DP may be folded on the portion having the flexibility without damaging the display panel DP or the display device DD, but embodiments according to the present disclosure are not limited thereto.

The display panel DP may display images. A self-emissive display panel, such as an organic light emitting display panel (OLED panel) using an organic light emitting diode as a light emitting element, a subminiature light emitting diode (micro-LED or nano-LED) display panel using a subminiature LED as a light emitting element, and a quantum dot organic light emitting display panel (QD OLED panel) using a quantum dot and an organic light emitting diode, may be used as the display panel DP. In addition, a non-emissive display panel such as a liquid crystal display (LCD) panel, an electro-phoretic display (EPD) panel, or an electro-wetting display (EWD) panel may be used as the display panel DP. In case that the non-emissive display panel is used as the display panel DP, the display device DD may include a backlight unit configured to supply light to the display panel DP. According to some embodiments, the display panel DP may be an organic light emitting display panel.

The display panel DP may include a substrate SUB, and pixels PXL provided on the substrate SUB.

The substrate SUB may include transparent insulating material to allow light transmission, but embodiments according to the present disclosure are not limited thereto. The substrate SUB may be a rigid substrate or a flexible substrate.

For example, the rigid substrate may be one of a glass substrate, a quartz substrate, a glass ceramic substrate, and a crystalline glass substrate.

The flexible substrate may be either a film substrate or a plastic substrate which includes polymer organic material. For example, the flexible substrate SUB may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, or cellulose acetate propionate.

One area of the substrate SUB may be provided as the display area DA in which the pixels PXL are located, and the other area of the substrate SUB may be provided as the non-display area NDA. For example, the substrate SUB may include the display area DA including a plurality of pixel areas PXA on which the respective pixels PXL are located, and the non-display area NDA arranged around a perimeter of the display area DA (or adjacent to the display area DA).

The non-display area NDA may be located adjacent to (e.g., in a periphery or outside a footprint of) the display area DA. The non-display area NDA may be provided on at least one side of the display area DA. For example, the non-display area NDA may enclose the perimeter (or edges) of the display area DA. A line component connected to each of the pixels PXL, and a driver connected to the line component and configured to drive the pixel PXL may be provided in the non-display area NDA.

Each of the pixels PXL may be provided in the display area DA of the substrate SUB. Each of the pixels PXL may include a light emitting element which emits white light and/or color light, and a pixel circuit configured to drive the light emitting element. The pixel circuit may include at least one transistor electrically connected to the light emitting element. Each pixel PXL may emit light of any one color among red, green, and blue, but is not limited thereto. Each pixel PXL may emit light of any one color among cyan, magenta, yellow, and white.

The pixels PXL may be arranged in a matrix form along pixel rows extending in a first direction DR1 and pixel columns extending in a second direction DR2 intersecting with the first direction DR1. However, the arrangement of the pixels PXL is not particularly limited. In other words, the pixels PXL may be arranged in various forms. Furthermore, in case that a plurality of pixels PXL are provided, the pixels PXL may have different surface areas (or different sizes). For example, in case that pixels PXL emit different colors of light, the pixels PXL may have different surface areas (or different sizes) or different shapes by colors.

The driver may provide a certain signal and a certain voltage to each pixel PXL through the line component to control the operation of the pixel PXL.

The display panel DP (or each of the pixels PXL) may include a pixel circuit layer PCL, a display element layer DPL, and an encapsulation layer TFE that are located on the substrate SUB.

The pixel circuit layer PCL may be provided on the substrate SUB, and include a transistor and signal lines connected to the transistor. For example, the transistor may have a shape in which an active pattern (or a semiconductor pattern), a gate electrode, a source electrode, and a drain electrode are successively stacked with insulating layers interposed therebetween. The semiconductor pattern may include amorphous silicon, poly silicon, low temperature poly silicon, and an organic semiconductor, and/or an oxide semiconductor. Although the gate electrode, the source electrode, and the drain electrode each may include one of aluminum (Al), copper (Cu), titanium (Ti), and molybdenum (Mo), embodiments according to the present disclosure are not limited thereto. In addition, the pixel circuit layer PCL may include at least one or more insulating layers.

The display element layer DPL may be located on the pixel circuit layer PCL. The display element layer DPL may include a light emitting element configured to emit light. Although the light emitting element may be, e.g., an organic light emitting diode, embodiments according to the present disclosure are not limited thereto. According to some embodiments, the light emitting element may be an inorganic light emitting element including inorganic light emitting material, or a light emitting element that emits light by changing the wavelength of light emitted using quantum dots.

The encapsulation layer TFE may be located on the display element layer DPL. The encapsulation layer TFE may be an encapsulation substrate or have the form of an encapsulation film made of multiple films. In case that the encapsulation layer TFE has the form of the encapsulation film, the encapsulation layer TFE may include an inorganic layer and/or an organic layer. For example, the encapsulation layer TFE may have a structure formed by successively stacking an inorganic layer, an organic layer, and an inorganic layer. The encapsulation layer TFE may prevent or reduce instances of contaminants such as external air or water permeating the display element layer DPL or the pixel circuit layer PCL.

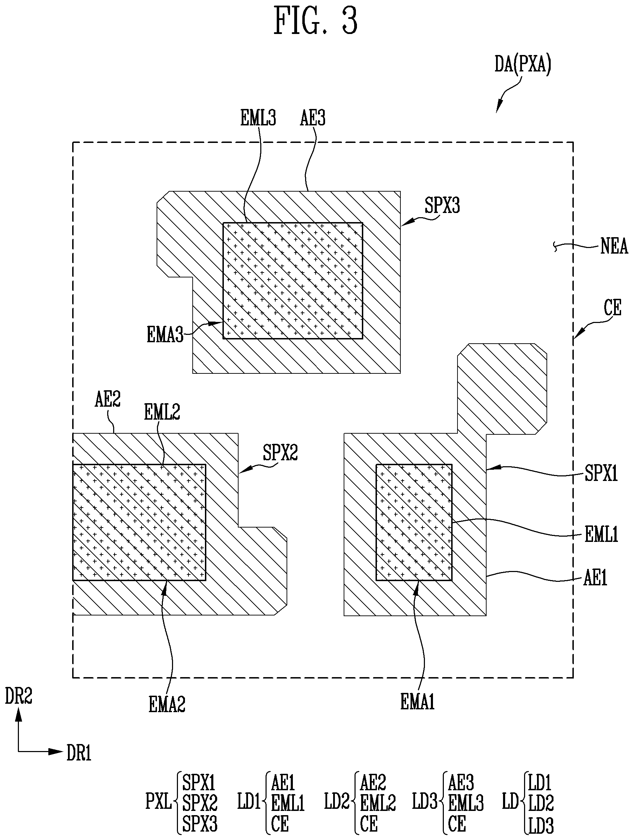

FIG. 3 is a schematic plan view illustrating aspects of a pixel PXL of FIG. 1, according to some embodiments.

Referring to FIGS. 1 to 3, a pixel PXL may be located in the display area DA. The pixel PXL may be located in a pixel area PXA provided in the display area DA. The pixel area PXA may include an emission area and a non-emission area NEA.

The pixel PXL may include a first sub-pixel SPX1, a second sub-pixel SPX2, and a third sub-pixel SPX3. The first sub-pixel SPX1 may emit light of a first color. The second sub-pixel SPX2 may emit light of a second color. The third sub-pixel SPX3 may emit light of a third color. For example, the light of the first color may correspond to light in a red wavelength band. The light of the second color may correspond to light in a green wavelength band. The light of the third color may correspond to light in a blue wavelength band. Embodiments of the present disclosure are not limited to the aforementioned example.

The first sub-pixel SPX1 may include a first emission area EMA1 and a non-emission area NEA which is adjacent to the first emission area EMA1 (or encloses at least one side of the first emission area EMA1). The second sub-pixel SPX2 may include a second emission area EMA2 and a non-emission area NEA which is adjacent to the second emission area EMA2 (or encloses at least one side of the second emission area EMA2). The third sub-pixel SPX3 may include a third emission area EMA3 and a non-emission area NEA which is adjacent to the third emission area EMA3 (or encloses at least one side of the third emission area EMA3).

Each of the first, second, and third sub-pixels SPX1, SPX2, and SPX3 may include a light emitting element LD configured to emit light, and circuit elements configured to drive the light emitting element LD. For example, the first sub-pixel SPX1 may include a first light emitting element LD1 configured to emit light, and circuit elements configured to drive the first light emitting element LD1. The second sub-pixel SPX2 may include a second light emitting element LD2 configured to emit light, and circuit elements configured to drive the second light emitting element LD2. The third sub-pixel SPX3 may include a third light emitting element LD3 configured to emit light, and circuit elements configured to drive the third light emitting element LD3.

The first light emitting element LD1 may include a first anode electrode AE1 (or a first pixel electrode), a first emission layer EML1, and a cathode electrode CE. The first emission area EMA1 may be an area in which light is emitted from the first emission layer EML1 of the first light emitting element LD1. The first emission area EMA1 may correspond to an area in which the first emission layer EML1 is located.

The second light emitting element LD2 may include a second anode electrode AE2 (or a second pixel electrode), a second emission layer EML2, and a cathode electrode CE. The second emission area EMA2 may be an area in which light is emitted from the second emission layer EML2 of the second light emitting element LD2. The second emission area EMA2 may correspond to an area in which the second emission layer EML2 is located.

The third light emitting element LD3 may include a third anode electrode AE3 (or a third pixel electrode), a third emission layer EML3, and a cathode electrode CE. The third emission area EMA3 may be an area in which light is emitted from the third emission layer EML3 of the third light emitting element LD3. The third emission area EMA3 may correspond to an area in which the third emission layer EML3 is located.

The first anode electrode AE1, the second anode electrode AE2, and the third anode electrode AE3 may be spaced apart from each other. The first emission layer EML1, the second emission layer EML2, and the third emission layer EML3 may be spaced apart from each other, but embodiments according to the present disclosure are not limited thereto. The cathode electrode CE may be provided in common to the first sub-pixel SPX1, the second sub-pixel SPX2, and the third sub-pixel SPX3.

The first sub-pixel SPX1, the second sub-pixel SPX2, and the third sub-pixel SPX3 may have substantially the same surface area, but embodiments according to the present disclosure are not limited thereto. According to some embodiments, the second sub-pixel SPX2 may have a larger surface area than the first sub-pixel SPX1. The third sub-pixel SPX3 may have a larger surface area than the second sub-pixel SPX2.

Each of the first sub-pixel SPX1, the second sub-pixel SPX2, and the third sub-pixel SPX3 may have a polygonal shape. For example, each of the first sub-pixel SPX1, the second sub-pixel SPX2, and the third sub-pixel SPX3 may have a rectangular shape, a hexagonal shape, or the like, but is not limited thereto. According to some embodiments, each of the first sub-pixel SPX1, the second sub-pixel SPX2, and the third sub-pixel SPX3 may have a circular shape, a semi-elliptical shape, and so on.

The arrangement of the sub-pixels shown in FIG. 3 is an illustrative example, and embodiments of the present disclosure are not limited thereto. Each pixel PXL may include two or more sub-pixels, and the sub-pixels may be arranged in various ways. Each of the sub-pixels may have various shapes. Each of the emission areas of the sub-pixels may also have various shapes.

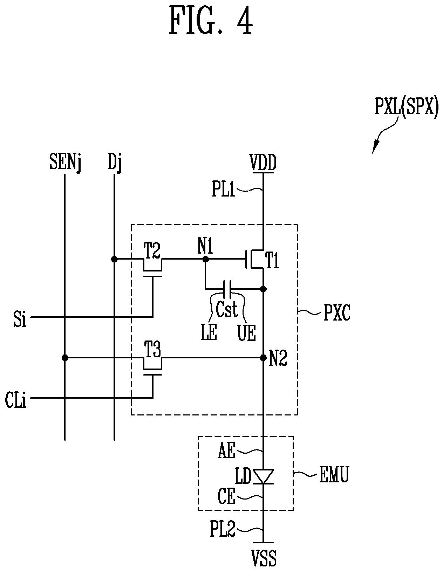

FIG. 4 is a schematic circuit diagram illustrating an electrical connection relationship of components included in each of the pixels PXL illustrated in FIG. 1. Although various components are illustrated in the pixel PXL of FIG. 4, embodiments according to the present disclosure are not limited thereto. For example, according to some embodiments, the pixel PXL may include additional components or fewer components without departing from the scope of embodiments according to the present disclosure.

For convenience of description, FIG. 4 illustrates a pixel PXL (or a sub-pixel SPX) that is positioned on an i-th horizontal line (or an i-th pixel row) and connected to a j-th data line Dj (where i and j are natural numbers).

Referring to FIGS. 1 to 4, the pixel PXL (or the sub-pixel SPX) may include an emission component EMU configured to generate light with a luminance corresponding to a data signal. Furthermore, the pixel PXL may further include a pixel circuit PXC configured to drive the emission component EMU.

The emission component EMU may include a light emitting element LD connected between a first power line PL1 configured to receive a first power voltage VDD and a second power line PL2 configured to receive a second power voltage VSS. For example, the emission component EMU may include a light emitting element LD which include a first electrode AE (e.g., "pixel electrode" or "anode electrode") connected to the first power voltage (or first power supply) VDD via the pixel circuit PXC and the first power line PL1, and a second electrode CE (e.g., "common electrode" or "cathode electrode") connected to the second power voltage (or second power supply) VSS via the second power line PL2. The first power voltage VDD and the second power voltage VSS may have different potentials. Here, a difference in potential between the first power voltage VDD and the second power voltage VSS may be set to be equal to or greater than a threshold voltage of the light emitting element LD during an emission period of the pixel PXL.

In case that the pixel PXL (or the sub-pixel SPX) is located on the i-th pixel row and the j-th pixel column in the display area DA, the pixel circuit PXC of the pixel PXL may be electrically connected to an i-th scan line Si and a j-th data line Dj. Furthermore, the pixel circuit PXC may be electrically connected to an i-th control line CLi and a j-th sensing line SENj.

The pixel circuit PXC may include first, second, and third transistors T1, T2, and T3, and a storage capacitor Cst.

The first transistor T1 may be a driving transistor configured to control driving current to be applied to the light emitting element LD and be electrically connected between the first power supply VDD and the light emitting element LD. In detail, a first terminal of the first transistor T1 may be electrically connected to the first power supply VDD by the first power line PL1. A second terminal of the first transistor T1 may be electrically connected to a second node N2. A gate electrode of the first transistor T1 may be electrically connected to a first node N1. The first transistor T1 may control, in response to a voltage applied to the first node N1, driving current to be applied from the first power supply VDD to the light emitting element LD through the second node N2. According to some embodiments, the first terminal of the first transistor T1 may be a drain electrode, and the second terminal of the first transistor T1 may be a source electrode, and embodiments according to the present disclosure are not limited thereto. According to some embodiments, the first terminal may be a source electrode, and the second terminal may be a drain electrode.

The second transistor T2 may be a switching transistor configured to select a pixel PXL in response to a scan signal and activate the pixel PXL, and may be electrically connected between the j-th data line Dj and the first node N1. A first terminal of the second transistor T2 may be electrically connected to the j-th data line Dj. A second terminal of the second transistor T2 may be electrically connected to the first node N1 (or the gate electrode of the first transistor T1). A gate electrode of the second transistor T2 may be electrically connected to the i-th scan line Si. The first terminal and the second terminal of the second transistor T2 are different terminals, and, for example, if the first terminal is a drain electrode, the second terminal may be a source electrode.

In case that a scan signal of a gate-on voltage (e.g., a high level voltage) is supplied from the i-th scan line Si, the second transistor T2 may be turned on to electrically connect the j-th data line Dj to the first node N1. The first node N1 may be a point at which the second terminal of the second transistor T2 and the gate electrode of the first transistor T1 are connected to each other. The second transistor T2 may transmit a data signal to the gate electrode of the first transistor T1.

The third transistor T3 may acquire a sensing signal through the j-th sensing line SENj by electrically connecting the first transistor T1 to the j-th sensing line SENj, and may detect, using the sensing signal, characteristics of the pixel PXL such as a threshold voltage of the first transistor T1. Information about the characteristics of the pixel PXL may be used to convert image data such that a deviation in characteristic between pixels PXL can be compensated for. A second terminal of the third transistor T3 may be electrically connected to the second terminal of the first transistor T1. A first terminal of the third transistor T3 may be electrically connected to the j-th sensing line SENj. A gate electrode of the third transistor T3 may be electrically connected to the i-th control line CLi. The first terminal may be a drain electrode, and the second terminal may be a source electrode.

The third transistor T3 may be an initialization transistor configured to initialize the second node N2, and may be turned on in case that a sensing control signal is supplied thereto from the i-th control line CLi, thus transmitting an initialization voltage to the second node N2.

The storage capacitor Cst may include a lower electrode LE (or a first storage electrode) and an upper electrode UE (or a second storage electrode). The lower electrode LE may be electrically connected to the first node N1. The upper electrode UE may be electrically connected to the second node N2. The storage capacitor Cst may be charged with a data voltage corresponding to a data signal to be supplied to the first node N1 during one frame period. Hence, the storage capacitor Cst may store a voltage corresponding to a difference between a voltage of the gate electrode of the first transistor T1 and a voltage of the second node N2.

Although FIG. 4 illustrates one or more embodiments where all of the first to third transistors T1, T2, and T3 are N-type transistors, the present disclosure is not limited thereto. For example, at least one of the first to third transistors T1, T2, or T3 may be changed to a P-type transistor.

The structure of the pixel circuit PXC may be changed in various ways.

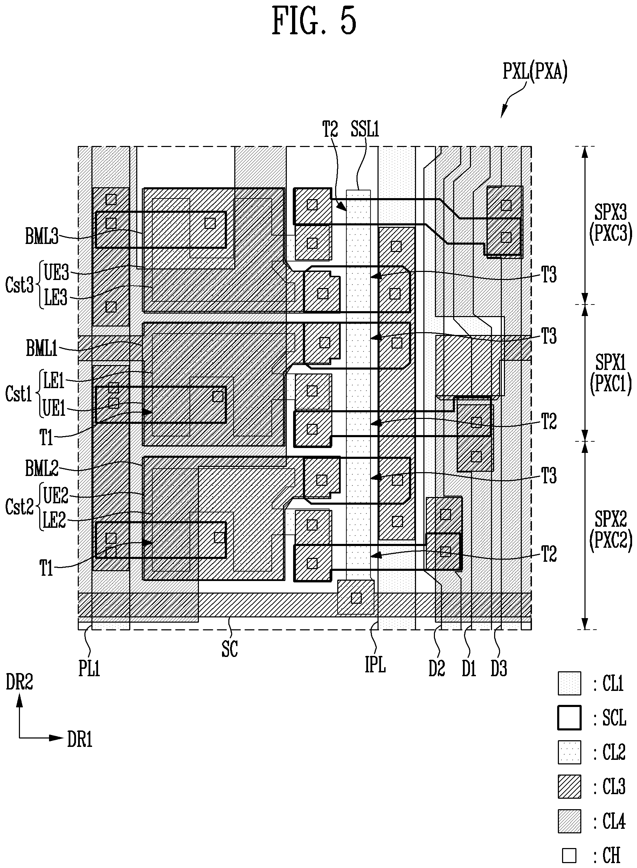

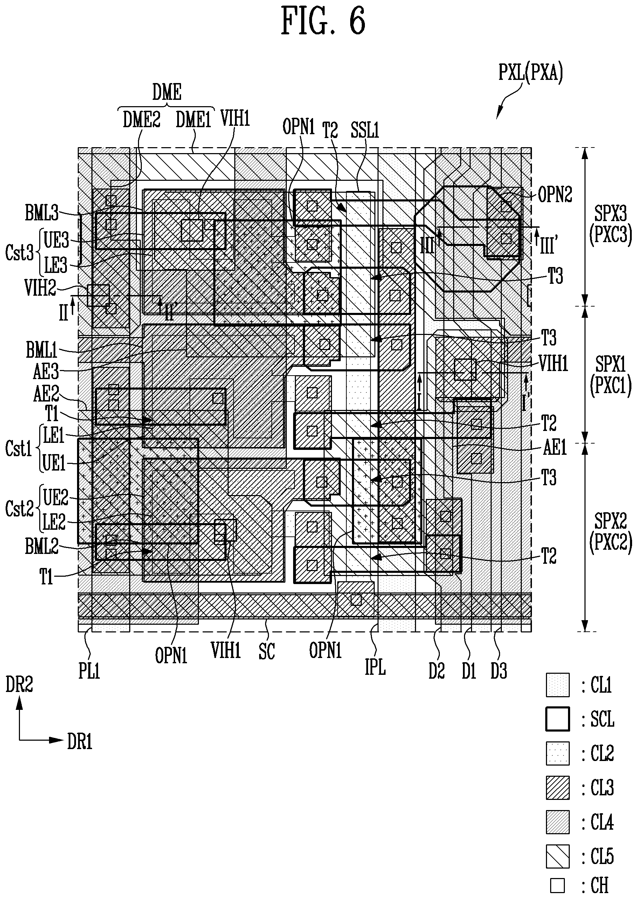

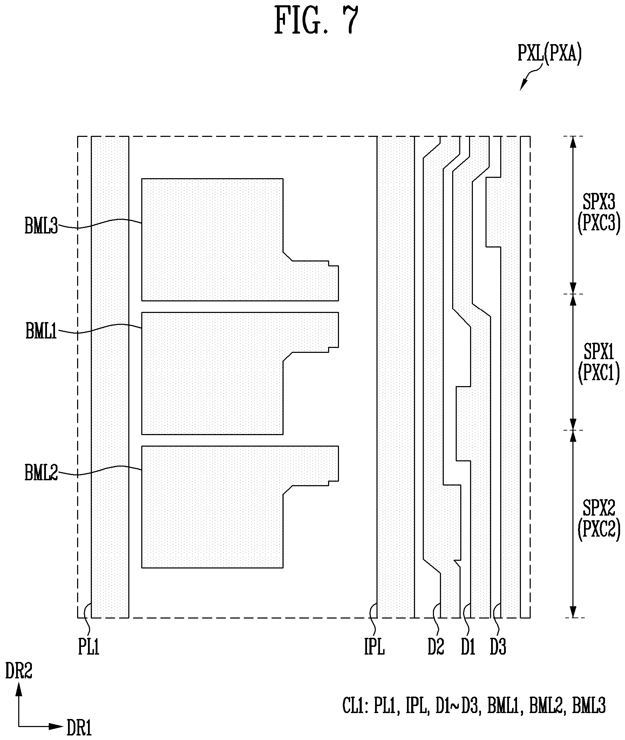

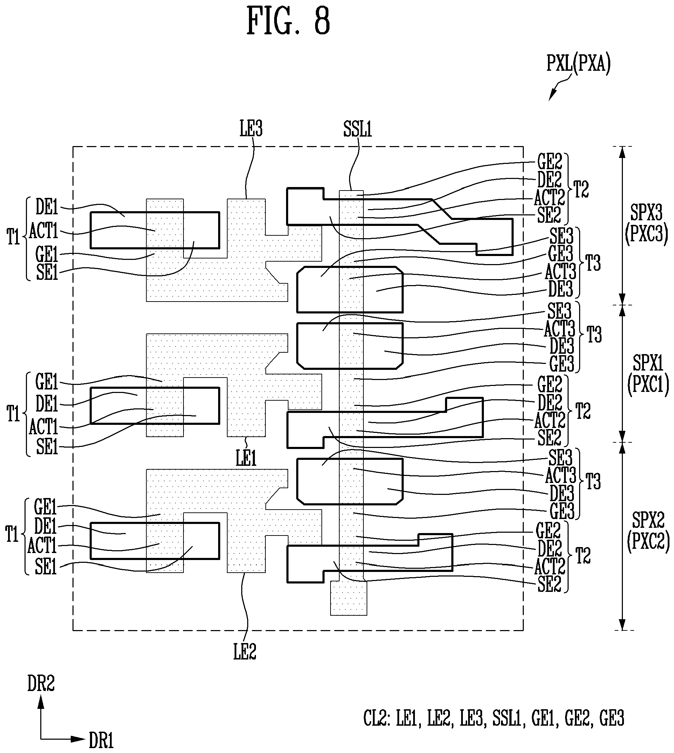

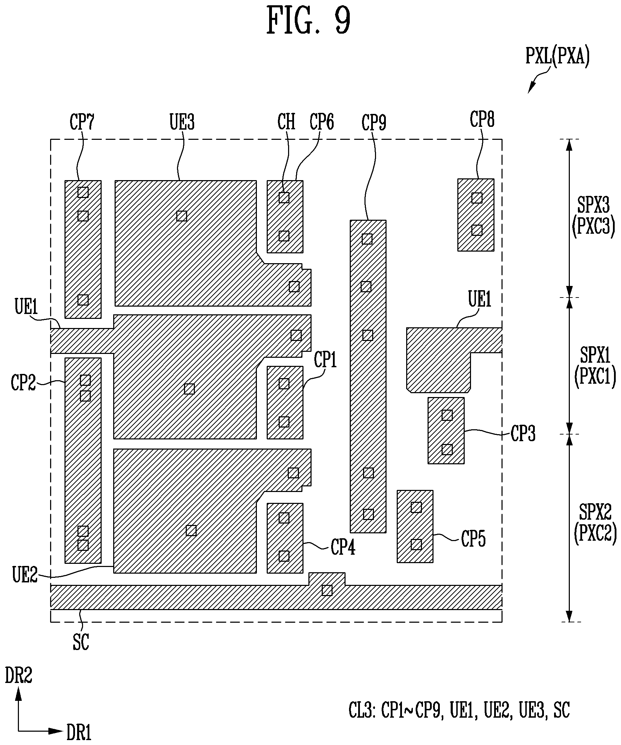

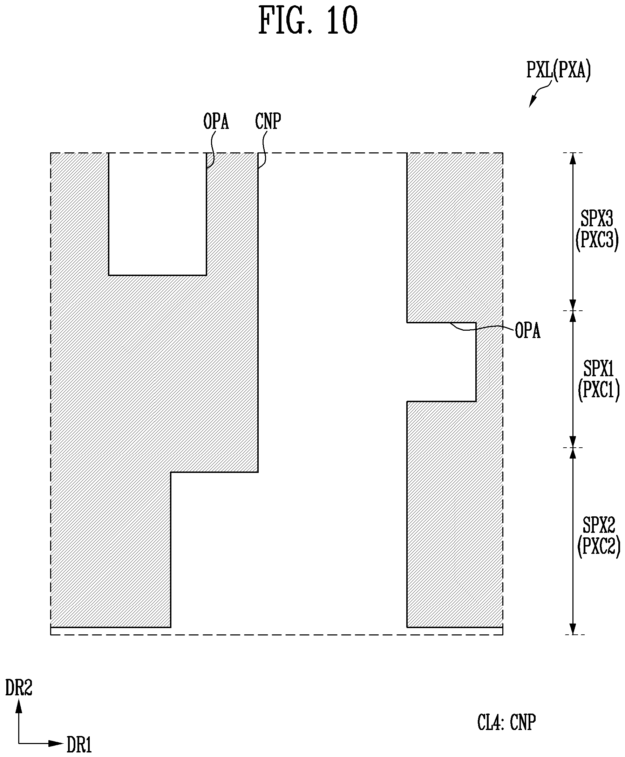

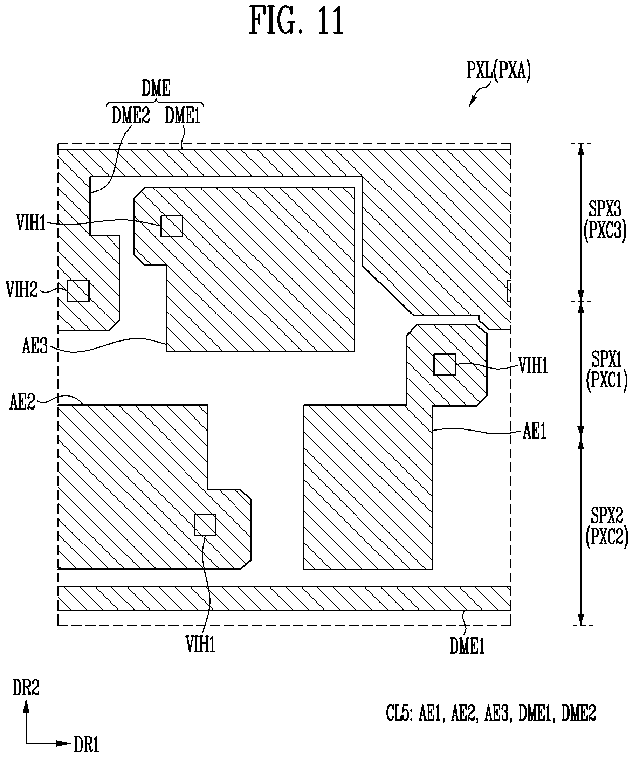

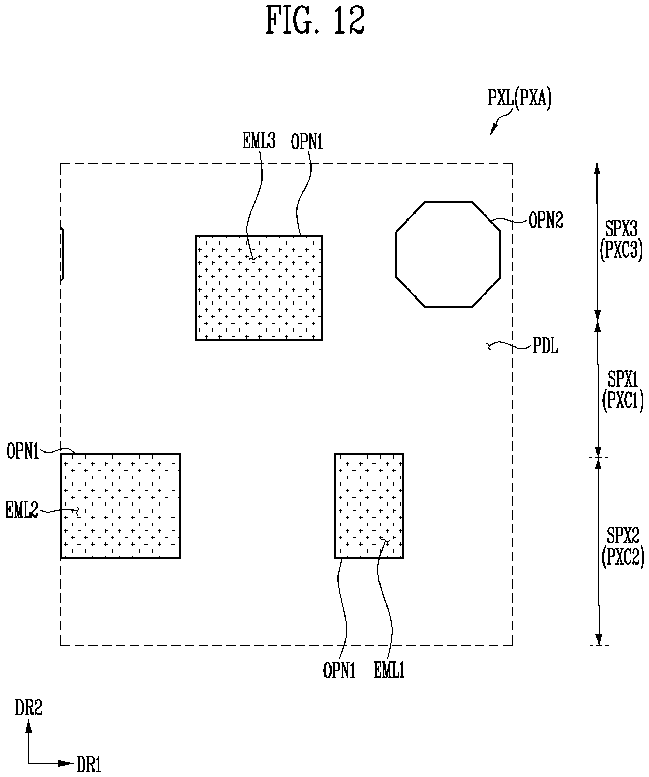

FIG. 5 and FIG. 6 are schematic plan views illustrating the pixel PXL according to some embodiments. FIG. 7 is a schematic plan view illustrating only components included in a first conductive layer CL1 in the pixel PXL of FIG. 6. FIG. 8 is a schematic plan view illustrating transistors in the pixel PXL of FIG. 6 and only components included in a second conductive layer CL2. FIG. 9 is a schematic plan view illustrating only components included in a third conductive layer CL3 in the pixel PXL of FIG. 6. FIG. 10 is a schematic plan view illustrating only components included in a fourth conductive layer CL4 in the pixel PXL of FIG. 6. FIG. 11 is a schematic plan view illustrating only components included in a fifth conductive layer CL5 in the pixel PXL of FIG. 6. FIG. 12 is a schematic plan view illustrating an emission layer and a pixel defining layer PDL in the pixel PXL of FIG. 6.

Referring to FIGS. 1 to 12, the pixel PXL according to some embodiments may be located in the pixel area PXA. The pixel PXL may include a first sub-pixel SPX1, a second sub-pixel SPX2, and a third sub-pixel SPX3.

The first sub-pixel SPX1 may include a first pixel circuit PXC1, and a first light emitting element (refer to "LD1" of FIG. 3) configured to be driven by the first pixel circuit PXC1. The second sub-pixel SPX2 may include a second pixel circuit PXC2, and a second light emitting element (refer to "LD2" of FIG. 3) configured to be driven by the second pixel circuit PXC2. The third sub-pixel SPX3 may include a third pixel circuit PXC3, and a third light emitting element (refer to "LD3" of FIG. 3) configured to be driven by the third pixel circuit PXC3.

Signal lines electrically connected to the first to third sub-pixels SPX1 to SPX3 may be located in the pixel area PXA. For example, a scan line SC, data lines D1, D2, and D3, a first power line PL1, and an initialization power line IPL may be located in the pixel area PXA.

The scan line SC may extend in the first direction DR1. The scan line SC may be selectively supplied with a scan signal and a sensing control signal. The scan line SC may be formed of or comprise the third conductive layer CL3. The third conductive layer CL3 (or a first source-drain layer) may be formed of or comprise a single layer or multiple layers made of molybdenum (Mo), copper (Cu), aluminum (Al), chromium (Cr), gold (Au), silver (Ag), titanium (Ti), nickel (Ni), neodymium (Nd), indium (In), tin (Sn), and an oxide or alloy thereof.

The scan line SC may supply a scan signal to a second gate electrode GE2 of a second transistor T2 of each of the first to third pixel circuits PXC1 to PXC3 during a driving period of the first to third light emitting elements LD1 to LD3, and may supply a sensing control signal to a third gate electrode GE3 of a third transistor T3 of each of the first to third pixel circuits PXC1 to PXC3 during a sensing period. The scan line SC may be electrically connected to a first sub-scan line SSL1 through a corresponding contact hole CH.

The first sub-scan line SSL1 may extend in the second direction DR2, and may be formed of or comprise the second conductive layer CL2. The second conductive layer CL2 (or a gate layer) may include the same material as the third conductive layer CL3, or may include one or more suitable (or selected) materials among materials described as the constituent material of the third conductive layer CL3, but embodiments according to the present disclosure are not limited thereto. The first sub-scan line SSL1 may be electrically connected to the scan line SC through the corresponding contact hole CH.

The first sub-scan line SSL1 may be integrally formed with the second gate electrode GE2 of the second transistor T2 of each of the first, second, and third pixel circuits PXC1, PXC2, and PXC3. For example, a portion of the first sub-scan line SSL1 may be the second gate electrode GE2 of the second transistor T2 of each of the first to third pixel circuits PXC1 to PXC3.

Furthermore, the first sub-scan line SSL1 may be integrally formed with the third gate electrode GE3 of the third transistor T3 of each of the first to third pixel circuits PXC1 to PXC3. For example, another portion of the first sub-scan line SSL1 may be the third gate electrode GE3 of the third transistor T3 of each of the first to third pixel circuits PXC1 to PXC3.

The data lines D1, D2, and D3 may include a second data line D2, a first data line D1, and a third data line D3 which extend in the second direction DR2 and are arranged in the first direction DR1. Each of the first to third data lines D1 to D3 may be supplied with a data signal.

The first data line D1 may be electrically connected to the second transistor T2 of the first pixel circuit PXC1 (or the first sub-pixel SPX1). The second data line D2 may be electrically connected to the second transistor T2 of the second pixel circuit PXC2 (or the second sub-pixel SPX2). The third data line D3 may be electrically connected to the third transistor T3 of the third pixel circuit PXC3 (or the third sub-pixel SPX3). Each of the first to third data lines D1 to D3 may be formed of or comprise the first conductive layer CL1. The first conductive layer CL1 (or a bottom metal layer) may include the same material as the third conductive layer CL3, or may include one or more suitable (or selected) materials among materials described as the constituent material of the third conductive layer CL3, but embodiments according to the present disclosure are not limited thereto.

The first power line PL1 may be supplied with the first power voltage VDD. The first power line PL1 may extend in the second direction DR2. The first power line PL1 may be spaced apart from the first to third data lines D1 to D3. The first power line PL1 may be formed of or comprise the first conductive layer CL1, and may be formed through the same process as the first to third data lines D1 to D3 and located on the same layer as the first to third data lines D1 to D3. According to some embodiments, the first power line PL1 may be provided in common to the first to third sub-pixels SPX1 to SPX3. For example, the first to third sub-pixels SPX1 to SPX3 may share the first power line PL1. The first power line PL1 may be electrically connected to the first transistor T1 of each of the first to third pixel circuits PXC1 to PXC3 (or the first to third sub-pixels SPX1 to SPX3). The first power line PL1 may be electrically connected to each of a second conductive pattern CP2 and a seventh conductive pattern CP7 through a corresponding contact hole CH.

Each of the second and seventh conductive patterns CP2 and CP7 may be formed of or comprise the third conductive layer CL3, and may overlap the first power line PL1. The second conductive pattern CP2 and the seventh conductive pattern CP7 may be spaced apart from each other. The first power line PL1 may be electrically connected, through a corresponding contact hole CH, to each of the second and seventh conductive patterns CP2 and CP7 positioned in different layers, thus being implemented as a double-layer structure. Hence, line resistance of the first power line PL1 may be reduced.

The initialization power line IPL may extend in the second direction DR2, and may be formed of or comprise the first conductive layer CL1. The initialization power line IPL may be spaced apart from the first power line PL1, and the first to third data lines D1 to D3. The initialization power line IPL may be the j-th sensing line SENj described with reference to FIG. 4. The initialization power line IPL may be supplied with an initialization voltage. The initialization power line IPL may be electrically connected to the third transistor T3 of each of the first to third pixel circuits PXC1 to PXC3 (or the first to third sub-pixels SPX1 to SPX3). The initialization power line IPL may overlap a ninth conductive pattern CP9 extending in the second direction DR2. The initialization power line IPL may be electrically connected to the ninth conductive pattern CP9 through a corresponding contact hole CH.

The ninth conductive pattern CP9 may be formed of or comprise the third conductive layer CL3, and may be electrically connected to the initialization power line IPL through a corresponding contact hole CH. The ninth conductive pattern CP9 may be electrically connected to a third drain electrode DE3 of the third transistor T3 of each of the first to third pixel circuits PXC1 to PXC3.

The initialization power line IPL may be electrically connected to the ninth conductive pattern CP9 located in a different layer, thus being implemented as a double-layer structure. Hence, line resistance of the initialization power line IPL may be reduced, thus resulting in reduced signal distortion.

The first power line PL1, the initialization power line IPL, the scan line SC, and the first sub-scan line SSL1 may be common components provided in common to the first to third sub-pixels SPX1 to SPX3.

Each of the first, second, and third pixel circuits PXC1, PXC2, and PXC3 may include a first transistor T1, a second transistor T2, a third transistor T3, and a storage capacitor. For example, the first pixel circuit PXC1 may include first to third transistors T1, T2, and T3, and a first storage capacitor Cst1. The second pixel circuit PXC2 may include first to third transistors T1, T2, and T3, and a second storage capacitor Cst2. The third pixel circuit PXC3 may include first to third transistors T1, T2, and T3, and a third storage capacitor Cst3.

The first transistor T1 of each of the first to third pixel circuits PXC1, PXC2, and PXC3 may correspond to the first transistor T1 of FIG. 4. The second transistor T2 of each of the first to third pixel circuits PXC1, PXC2, and PXC3 may correspond to the second transistor T2 of FIG. 4. The third transistor T3 of each of the first to third pixel circuits PXC1, PXC2, and PXC3 may correspond to the third transistor T3 of FIG. 4.

The first pixel circuit PXC1, the second pixel circuit PXC2, and the third pixel circuit PXC3 may have a substantially similar or identical structure. Hereinafter, descriptions will be made centered on the first pixel circuit PXC1, and descriptions of the second pixel circuit PXC2 and the third pixel circuit PXC3 will be simplified.

The first pixel circuit PXC1 may include first to third transistors T1, T2, and T3, and a first storage capacitor Cst1.

The first transistor T1 may include a first gate electrode GE1, a first active pattern ACT1, a first source electrode SE1 (or a first source area), and a first drain electrode DE1 (or a first drain area).

The first gate electrode GE1 may be electrically connected to the second transistor T2 through the first conductive pattern CP1. The first gate electrode GE1 may be formed of or comprise the second conductive layer CL2, and may have an island shape.

The first conductive pattern CP1 may be positioned at the first node N1 (refer to "N1" of FIG. 4), which is a connection potion at which the first gate electrode GE1 of the first transistor T1 and a second source electrode SE2 of the second transistor T2 are electrically connected to each other. The first conductive pattern CP1 may be formed of or comprise the third conductive layer CL3. A first end of the first conductive pattern CP1 may be electrically connected to the first gate electrode GE1 through a corresponding contact hole CH. A second end of the first conductive pattern CP1 may be electrically connected to the second source electrode SE2 through a corresponding contact hole CH.

Each of the first active pattern ACT1, the first source electrode SE1, and the first drain electrode DE1 may be formed of or comprise a semiconductor layer SCL. Each of the first active pattern ACT1, the first source electrode SE1, and the first drain electrode DE1 may be a semiconductor pattern formed of or comprise amorphous silicon, an oxide semiconductor, or the like. Each of the first active pattern ACT1, the first source electrode SE1, and the first drain electrode DE1 may be formed of or comprise an undoped semiconductor layer or a semiconductor layer doped with an impurity. For example, each of the first source electrode SE1 and the first drain electrode DE1 may be formed of or comprise a semiconductor pattern doped with an impurity. The first active pattern ACT1 may be formed of or comprise an undoped semiconductor pattern.

The first active pattern ACT1 may be one area of the semiconductor layer SCL overlapping the first gate electrode GE1. The first active pattern ACT1 may form a channel area of the first transistor T1, and may be an undoped semiconductor pattern.

The first source electrode SE1 may be connected to a first end of the first active pattern ACT1. The first source electrode SE1 may be electrically connected to a first upper electrode UE1 through a corresponding contact hole CH.

The first drain electrode DE1 may be connected to a second end of the first active pattern ACT1. The first drain electrode DE1 may be electrically connected to the second conductive pattern CP2 through a corresponding contact hole CH.

The second conductive pattern CP2 may overlap the first power line PL1, and may be electrically connected to the first power line PL1 through a corresponding contact hole CH. The first drain electrode DE1 and the first power line PL1 may be electrically connected to each other through the second conductive pattern CP2.

A first bottom metal pattern BML1 may be located under the first transistor T1. The first bottom metal pattern BML1 may be formed of or comprise the first conductive layer CL1. The first bottom metal pattern BML1 may overlap the first transistor T1 (or the first storage capacitor Cst1) in a plan view. The first bottom metal pattern BML1 may shield the first transistor T1 (or the first storage capacitor Cst1) from the lower side. A constant voltage (e.g., the first power voltage VDD) may be applied to the first bottom metal pattern BML1, but the embodiments of present disclosure are not limited thereto.

The second transistor T2 may include a second gate electrode GE2, a second active pattern ACT2, a second source electrode SE2 (or a second source area), and a second drain electrode DE2 (or a second drain area).

The second gate electrode GE2 may be integrally formed with the first sub-scan line SSL1. The second gate electrode GE2 may be regarded as one area of the first sub-scan line SSL1. As the first sub-scan line SSL1 is electrically connected to the scan line SC through a corresponding contact hole CH, a certain signal (e.g., a scan signal) applied to the scan line SC may be supplied to the second gate electrode GE2.

Each of the second active pattern ACT2, the second source electrode SE2, and the second drain electrode DE2 may be formed of or comprise the semiconductor layer SCL. Each of the second active pattern ACT2, the second source electrode SE2, and the second drain electrode DE2 may be a semiconductor pattern formed of or comprise amorphous silicon, an oxide semiconductor, or the like. Each of the second active pattern ACT2, the second source electrode SE2, and the second drain electrode DE2 may be formed of or comprise an undoped semiconductor pattern or a semiconductor pattern doped with an impurity.

The second active pattern ACT2 may be one area of the semiconductor layer SCL that overlaps the second gate electrode GE2, and may be a channel area of the second transistor T2.

The second source electrode SE2 may be connected to a first end of the second active pattern ACT2. The second source electrode SE2 may be electrically connected to the first gate electrode GE1 by the first conductive pattern CP1.

The second drain electrode DE2 may be connected to a second end of the second active pattern ACT2. The second drain electrode DE2 may be electrically connected to the first data line D1 by a third conductive pattern CP3.

The third conductive pattern CP3 may be formed of or comprise the third conductive layer CL3. A first end of the third conductive pattern CP3 may be electrically connected to the second drain electrode DE2 through a corresponding contact hole CH. Furthermore, a second end of the third conductive pattern CP3 may be electrically connected to the first data line D1 through a corresponding contact hole CH. The second drain electrode DE2 and the first data line D1 may be electrically connected to each other by the third conductive pattern CP3.

The third transistor T3 may include a third gate electrode GE3, a third active pattern ACT3, a third source electrode SE3 (or a third source area), and a third drain electrode DE3 (or a third drain area).

The third gate electrode GE3 may be integrally formed with the first sub-scan line SSL1, and may be regarded as another area of the first sub-scan line SSL1. As the first sub-scan line SSL1 is electrically connected with the scan line SC, a certain signal (e.g., a sensing control signal) applied to the scan line SC may be supplied to the third gate electrode GE3.

Each of the third active pattern ACT3, the third source electrode SE3, and the third drain electrode DE3 may be formed of or comprise the semiconductor layer SCL. Each of the third active pattern ACT3, the third source electrode SE3, and the third drain electrode DE3 may be a semiconductor pattern formed of or comprise poly silicon, amorphous silicon, an oxide semiconductor, or the like. Each of the third active pattern ACT3, the third source electrode SE3, and the third drain electrode DE3 may be formed of or comprise an undoped semiconductor pattern or a semiconductor pattern doped with an impurity.

The third active pattern ACT3 may be one area of the semiconductor layer SCL that overlaps the third gate electrode GE3, and may be a channel area of the third transistor T3.

The third source electrode SE3 may be connected to a first end of the third active pattern ACT3. The third source electrode SE3 may be electrically connected to the first upper electrode UE1 through a corresponding contact hole CH.

The third drain electrode DE3 may be connected to a second end of the third active pattern ACT3. The third drain electrode DE3 may be electrically connected to the initialization power line IPL by the ninth conductive pattern CP9.

The first storage capacitor Cst1 may include a first lower electrode LE1 and a first upper electrode UE1. The first storage capacitor Cst1 may correspond to the storage capacitor Cst of FIG. 4.

The first lower electrode LE1 may be integrally provided with the first gate electrode GE1. The first lower electrode LE1 may be formed of or comprise the second conductive layer CL2.

The first upper electrode UE1 may be arranged to overlap the first lower electrode LE1 in a plan view, and have a size (or a surface area) greater than the first lower electrode LE1, but embodiments of the present disclosure are not limited thereto. The first upper electrode UE1 may be formed of or comprise the third conductive layer CL3. The first upper electrode UE1 may overlap each of the first and third source electrodes SE1 and SE3, in a plan view. One area of the first upper electrode UE1 may be electrically connected to the first source electrode SE1 through a corresponding contact hole CH. Another area of the first upper electrode UE1 may be electrically connected to the third source electrode SE3 through a corresponding contact hole CH. The first source electrode SE1, the third source electrode SE3, the first upper electrode UE1 may be electrically connected to each other.

In the first pixel circuit PXC1 having the aforementioned configuration, the first upper electrode UE1 may be electrically connected to the first pixel electrode AE1 through a corresponding first via hole VIH1. The first via hole VIH1 may be formed by opening a portion of at least one insulating layer positioned between the first upper electrode UE1 and the first pixel electrode AE1. One area of the first upper electrode UE1 may be exposed through the first via hole VIH1. The first via hole VIH1 may be positioned at the second node (refer to "N2" of FIG. 4) that is a connection point at which the first pixel circuit PXC1 and the first light emitting element LD1 are electrically connected to each other. For example, a point at which the first upper electrode UE1 of the first pixel circuit PXC1 and the first pixel electrode AE1 of the first light emitting element LD1 are electrically connected to each other through the first via hole VIH1 may become the second node N2.

The first pixel electrode AE1 (referred to as "first electrode" or "anode electrode") may be formed of or comprise the fifth conductive layer CL5. The first pixel electrode AE1 may correspond to the first electrode AE of FIG. 4. One area of the first pixel electrode AE1 may be exposed through a first opening OPN1 of the pixel defining layer PDL. The first emission layer EML1 may be positioned in one area on the first pixel electrode AE1 that is exposed through the first opening OPN1.

The second pixel circuit PXC2 may include a first transistor T1, a second transistor T2, a third transistor T3, and a second storage capacitor Cst2.

The first transistor T1 may include a first gate electrode GE1, a first active pattern ACT1, a first source electrode SE1 (or a first source area), and a first drain electrode DE1 (or a first drain area).

The first gate electrode GE1 may be electrically connected to a second source electrode SE2 of the second transistor T2 by a fourth conductive pattern CP4.

The fourth conductive pattern CP4 may be positioned at the first node N1, which is a connection potion at which the first gate electrode GE1 and the second source electrode SE2 are electrically connected to each other. The fourth conductive pattern CP4 may be formed of or comprise the third conductive layer CL3. A first end of the fourth conductive pattern CP4 may be electrically connected to the first gate electrode GE1 through a corresponding contact hole CH. A second end of the fourth conductive pattern CP4 may be electrically connected to the second source electrode SE2 through a corresponding contact hole CH.

The first active pattern ACT1 may be a channel area of the first transistor T1.

The first source electrode SE1 may be connected to a first end of the first active pattern ACT1. The first source electrode SE1 may be electrically connected to a second upper electrode UE2 through a corresponding contact hole CH.

The first drain electrode DE1 may be connected to a second end of the first active pattern ACT1. The first drain electrode DE1 may be electrically connected to the first power line PL1 by the second conductive pattern CP2.

A second bottom metal pattern BML2 may be located under the first transistor T1. The second bottom metal pattern BML2 may be formed of or comprise the first conductive layer CL1. The second bottom metal pattern BML2 may shield the first transistor T1 (or the second storage capacitor Cst2) from the lower side. A constant voltage may be applied to the second bottom metal pattern BML2, but embodiments of the present disclosure are not limited thereto.

The second transistor T2 may include a second gate electrode GE2, a second active pattern ACT2, the second source electrode SE2 (or a second source area), and a second drain electrode DE2 (or a second drain area).

The second gate electrode GE2 may be integrally provided with the first sub-scan line SSL1 and be electrically connected with the scan line SC. The second gate electrode GE2 may be formed of or comprise the second conductive layer CL2.

The second active pattern ACT2 may be a channel area of the second transistor T2.

The second source electrode SE2 may be connected to a first end of the second active pattern ACT2. The second source electrode SE2 may be electrically connected to the first gate electrode GE1 by the fourth conductive pattern CP4.

The second drain electrode DE2 may be connected to a second end of the second active pattern ACT2. The second drain electrode DE2 may be electrically connected to the second data line D2 by a fifth conductive pattern CP5.

The fifth conductive pattern CP5 may be formed of or comprise the third conductive layer CL3. A first end of the fifth conductive pattern CP5 may be electrically connected to the second drain electrode DE2 through a corresponding contact hole CH. Furthermore, a second end of the fifth conductive pattern CP5 may be electrically connected to the second data line D2 through a corresponding contact hole CH. The second drain electrode DE2 and the second data line D2 may be electrically connected to each other by the fifth conductive pattern CP5.

The third transistor T3 may include a third gate electrode GE3, a third active pattern ACT3, a third source electrode SE3 (or a third source area), and a third drain electrode DE3 (or a third drain area).

The third gate electrode GE3 may be formed of or comprise the second conductive layer CL2. The third gate electrode GE3 may be integrally formed with the first sub-scan line SSL1 and be electrically connected with the scan line SC.

The third active pattern ACT3 may be a channel area of the third transistor T3.

The third source electrode SE3 may be connected to a first end of the third active pattern ACT3. The third source electrode SE3 may be electrically connected to the second upper electrode UE2 through a corresponding contact hole CH.

The third drain electrode DE3 may be connected to a second end of the third active pattern ACT3. The third drain electrode DE3 may be electrically connected to the initialization power line IPL by the ninth conductive pattern CP9.

The second storage capacitor Cst2 may include a second lower electrode LE2 and the second upper electrode UE2. The second storage capacitor Cst2 may correspond to the storage capacitor Cst of FIG. 4.

The second lower electrode LE2 may be integrally provided with the first gate electrode GE1. The second lower electrode LE2 may be formed of or comprise the second conductive layer CL2.

The second upper electrode UE2 may be arranged to overlap the second lower electrode LE2 in a plan view, and have a size (or a surface area) greater than the second lower electrode LE2, but embodiments of the present disclosure are not limited thereto. The second upper electrode UE2 may be formed of or comprise the third conductive layer CL3. The second upper electrode UE2 may overlap each of the first and third source electrodes SE1 and SE3, in a plan view. One area of the second upper electrode UE2 may be electrically connected to the first source electrode SE1 through a corresponding contact hole CH. Another area of the second upper electrode UE2 may be electrically connected to the third source electrode SE3 through a corresponding contact hole CH. The first source electrode SE1, the third source electrode SE3, and the second upper electrode UE2 may be electrically connected to each other.

In the second pixel circuit PXC2 having the aforementioned configuration, the second upper electrode UE2 may be electrically connected to the second pixel electrode AE2 through a corresponding first via hole VIH1. The first via hole VIH1 may be formed by opening a portion of at least one insulating layer positioned between the second upper electrode UE2 and the second pixel electrode AE2. One area of the second upper electrode UE2 may be exposed through the first via hole VIH1. The first via hole VIH1 may be positioned at the second node N2 that is a connection point at which the second pixel circuit PXC2 and the second light emitting element LD2 are electrically connected to each other. For example, a point at which the second upper electrode UE2 of the second pixel circuit PXC2 and the second pixel electrode AE2 of the second light emitting element LD2 are electrically connected to each other through the first via hole VIH1 may become the second node N2.

The second pixel electrode AE2 (referred to as "first electrode" or "anode electrode") may be formed of or comprise the fifth conductive layer CL5. The second pixel electrode AE2 may correspond to the first electrode AE of FIG. 4. One area of the second pixel electrode AE2 may be exposed through another first opening OPN1 of the pixel defining layer PDL. The second emission layer EML2 may be positioned in one area on the second pixel electrode AE2 that is exposed through the first opening OPN1.

The third pixel circuit PXC3 may include a first transistor T1, a second transistor T2, a third transistor T3, and a third storage capacitor Cst3.

The first transistor T1 may include a first gate electrode GE1, a first active pattern ACT1, a first source electrode SE1 (or a first source area), and a first drain electrode DE1 (or a first drain area).

The first gate electrode GE1 may be electrically connected to the second source electrode SE2 of the second transistor T2 by a sixth conductive pattern CP6.

The sixth conductive pattern CP6 may be positioned at the first node N1, which is a connection potion at which the first gate electrode GE1 and the second source electrode SE2 are electrically connected to each other. The sixth conductive pattern CP6 may be formed of or comprise the third conductive layer CL3. A first end of the sixth conductive pattern CP6 may be electrically connected to the first gate electrode GE1 through a corresponding contact hole CH. A second end of the sixth conductive pattern CP6 may be electrically connected to the second source electrode SE2 through a corresponding contact hole CH.

The first active pattern ACT1 may be a channel area of the first transistor T1.

The first source electrode SE1 may be connected to a first end of the first active pattern ACT1. The first source electrode SE1 may be electrically connected to a third upper electrode UE3 through a corresponding contact hole CH.

The first drain electrode DE1 may be connected to a second end of the first active pattern ACT1. The first drain electrode DE1 may be electrically connected to the first power line PL1 by the seventh conductive pattern CP7.

A third bottom metal pattern BML3 may be located under the first transistor T1. The third bottom metal pattern BML3 may be formed of or comprise the first conductive layer CL1. The third bottom metal pattern BML3 may shield the first transistor T1 (or the third storage capacitor Cst3) from the lower side. A constant voltage may be applied to the third bottom metal pattern BML3, but embodiments of the present disclosure are not limited thereto.

The second transistor T2 may include a second gate electrode GE2, a second active pattern ACT2, a second source electrode SE2 (or a second source area), and a second drain electrode DE2 (or a second drain area).

The second gate electrode GE2 may be integrally provided with the first sub-scan line SSL1 and be electrically connected with the scan line SC. The second gate electrode GE2 may be formed of or comprise the second conductive layer CL2.

The second active pattern ACT2 may be a channel area of the second transistor T2.

The second source electrode SE2 may be connected to a first end of the second active pattern ACT2. The second source electrode SE2 may be electrically connected to the first gate electrode GE1 by the sixth conductive pattern CP6.

The second drain electrode DE2 may be connected to a second end of the second active pattern ACT2. The second drain electrode DE2 may be electrically connected to the third data line D3 by an eighth conductive pattern CP8.

The eighth conductive pattern CP8 may be formed of or comprise the third conductive layer CL3. A first end of the eighth conductive pattern CP8 may be electrically connected to the second drain electrode DE2 through a corresponding contact hole CH. Furthermore, a second end of the eighth conductive pattern CP8 may be electrically connected to the third data line D3 through a corresponding contact hole CH. The second drain electrode DE2 and the third data line D3 may be electrically connected to each other by the eighth conductive pattern CP8.

The third transistor T3 may include a third gate electrode GE3, a third active pattern ACT3, a third source electrode SE3 (or a third source area), and a third drain electrode DE3 (or a third drain area).

The third gate electrode GE3 may be formed of or comprise the second conductive layer CL2. The third gate electrode GE3 may be integrally formed with the first sub-scan line SSL1 and be electrically connected with the scan line SC.

The third active pattern ACT3 may be a channel area of the third transistor T3.

The third source electrode SE3 may be connected to a first end of the third active pattern ACT3. The third source electrode SE3 may be electrically connected to the third upper electrode UE3 through a corresponding contact hole CH.

The third drain electrode DE3 may be connected to a second end of the third active pattern ACT3. The third drain electrode DE3 may be electrically connected to the initialization power line IPL by the ninth conductive pattern CP9.

The third storage capacitor Cst3 may include a third lower electrode LE3 and a third upper electrode UE3. The third storage capacitor Cst3 may correspond to the storage capacitor Cst of FIG. 4.

The third lower electrode LE3 may be integrally provided with the first gate electrode GE1. The third lower electrode LE3 may be formed of or comprise the second conductive layer CL2.

The third upper electrode UE3 may be arranged to overlap the third lower electrode LE3 in a plan view, and have a size (or a surface area) greater than the third lower electrode LE3, but embodiments of the present disclosure are not limited thereto. The third upper electrode UE3 may be formed of or comprise the third conductive layer CL3. The third upper electrode UE3 may overlap each of the first and third source electrodes SE1 and SE3, in a plan view. One area of the third upper electrode UE3 may be electrically connected to the first source electrode SE1 through a corresponding contact hole CH. Another area of the third upper electrode UE3 may be electrically connected to the third source electrode SE3 through a corresponding contact hole CH. The first source electrode SE1, the third source electrode SE3, and the third upper electrode UE3 may be electrically connected to each other.

In the third pixel circuit PXC3 having the aforementioned configuration, the third upper electrode UE3 may be electrically connected to the third pixel electrode AE3 through a corresponding first via hole VIH1. The first via hole VIH1 may be formed by opening a portion of at least one insulating layer positioned between the third upper electrode UE3 and the third pixel electrode AE3. One area of the third upper electrode UE3 may be exposed through the first via hole VIH1. The first via hole VIH1 may be positioned at the second node N2 that is a connection point at which the third pixel circuit PXC3 and the third light emitting element LD3 are electrically connected to each other. For example, a point at which the third upper electrode UE3 of the third pixel circuit PXC3 and the third pixel electrode AE3 of the third light emitting element LD3 are electrically connected to each other through the first via hole VIH1 may become the second node N2.

The third pixel electrode AE3 (referred to as "first electrode" or "anode electrode") may be formed of or comprise the fifth conductive layer CL5. The third pixel electrode AE3 may correspond to the first electrode AE of FIG. 4. One area of the third pixel electrode AE3 may be exposed through another first opening OPN1 of the pixel defining layer PDL. The third emission layer EML3 may be positioned in one area on the third pixel electrode AE3 that is exposed through the first opening OPN1.

A connection pattern CNP formed of or comprise the fourth conductive layer CL4 may be positioned in the pixel area PXA.

The connection pattern CNP may partially overlap the first to third pixel circuits PXC1 to PXC3. Furthermore, the connection pattern CNP may partially overlap signal lines. For example, the connection pattern CNP may partially overlap the initialization power line IPL and the first to third data lines D1 to D3. The connection pattern CNP may partially overlap the first to third storage capacitors Cst1 to Cst3.

The connection pattern CNP may be electrically connected to the second power line PL2 described with reference to FIG. 4. Therefore, the second power voltage VSS may be applied to the connection pattern CNP.

According to some embodiments, the connection pattern CNP may have a shape bypassing the second node N2 at which the first via hole VIH1 is positioned. For example, the connection pattern CNP may have a shape including an opening area OPA corresponding to the first via hole VIH1 positioned at the second node N2 in each of the first to third sub-pixels SPX1 to SPX3 (or the first to third pixel circuits PXC1 to PXC3).

In the first sub-pixel SPX1, in the case where the opening area OPA of the connection pattern CNP corresponds to the first via hole VIH1, the connection pattern CNP formed of or comprise the fourth conductive layer CL4 may not be arranged around the first via hole VIH1 between the first supper electrode UE1 and the first pixel electrode AE1. In other words, the connection pattern CNP formed of or comprise the fourth conductive layer CL4 may not be positioned around the first via hole VIH1 located at the second node N2 on which the first upper electrode UE1 and the first pixel electrode AE1 are electrically connected to each other. As described above, because no other conductive layer is positioned between the first upper electrode UE1 formed of or comprise the third conductive layer CL3 and the first pixel electrode AE1 formed of or comprise the fifth conductive layer CL5, the first via hole VIH1 through which one area of the first upper electrode UE1 is exposed may be formed by simultaneously (or at the same time) etching the insulating layers positioned between the first upper electrode UE1 and the first pixel electrode AE1.

In the second sub-pixel SPX2, in the case where the opening area OPA of the connection pattern CNP corresponds to the first via hole VIH1, the connection pattern CNP formed of or comprise the fourth conductive layer CL4 may not be arranged around the first via hole VIH1 between the second supper electrode UE2 and the second pixel electrode AE2. In other words, the connection pattern CNP formed of or comprise the fourth conductive layer CL4 may not be positioned around the first via hole VIH1 located at the second node N2 on which the second upper electrode UE2 and the second pixel electrode AE2 are electrically connected to each other. As described above, because no other conductive layer is positioned between the second upper electrode UE2 formed of or comprise the third conductive layer CL3 and the second pixel electrode AE2 formed of or comprise the fifth conductive layer CL5, the first via hole VIH1 through which one area of the second upper electrode UE2 is exposed may be formed by simultaneously (or at the same time) etching the insulating layers positioned between the second upper electrode UE2 and the second pixel electrode AE2.

In the third sub-pixel SPX3, in the case where the opening area OPA of the connection pattern CNP corresponds to the first via hole VIH1, the connection pattern CNP formed of or comprise the fourth conductive layer CL4 may not be arranged around the first via hole VIH1 between the third supper electrode UE3 and the third pixel electrode AE3. In other words, the connection pattern CNP formed of or comprise the fourth conductive layer CL4 may not be positioned around the first via hole VIH1 located at the second node N2 on which the third upper electrode UE3 and the third pixel electrode AE3 are electrically connected to each other. As described above, because no other conductive layer is positioned between the third upper electrode UE3 formed of or comprise the third conductive layer CL3 and the third pixel electrode AE3 formed of or comprise the fifth conductive layer CL5, the first via hole VIH1 through which one area of the third upper electrode UE3 is exposed may be formed by simultaneously (or at the same time) etching the insulating layers positioned between the third upper electrode UE3 and the third pixel electrode AE3.

According to some embodiments, the connection pattern CNP may be positioned over the first to third storage capacitors Cst1 to Cst 3, thus overlapping the first to third storage capacitors Cst1 to Cst3. In the case where the connection pattern CNP configured to receive the second power voltage VSS overlaps the first to third storage capacitors Cst1 to Cst3, the connection pattern CNP may be used as a shielding component provided to reduce or prevent or reduce instances of coupling caps occurring between adjacent storage capacitors.

In the pixel area PXA according to some embodiments, there may be positioned a dummy electrode DME formed of or comprise the fifth conductive layer CL5.

The dummy electrode DME may be spaced apart from the first to third pixel electrodes AE1 to AE3. According to some embodiments, the dummy electrode DME may not overlap the first via hole VIH1 in each of the first to third sub-pixels SPX1 to SPX3.

The dummy electrode DME may include a first dummy electrode DME1 and a second dummy electrode DME2. The first dummy electrode DME1 may extend in the first direction DR1. The second dummy electrode DME2 may extend in the second direction DR2.

The first dummy electrode DME1 and the second dummy electrode DME2 may be integrally formed and connected to each other. Due to the first dummy electrode DME1 and the second dummy electrode DME2 connected to each other, the dummy electrode DME may have a mesh structure. However, embodiments of the present disclosure are not limited to the aforementioned example. According to some embodiments, the first dummy electrode DME1 and the second dummy electrode DME2 may be spaced apart from each other rather than being connected to each other.

The second dummy electrode DME2 may overlap the connection pattern CNP configured of the fourth conductive layer CL4. The second dummy electrode DME2 formed of or comprise the fifth conductive layer CL5 may be electrically connected, through a second via hole VIH2, to the connection pattern CNP formed of or comprise the fourth conductive layer CL4. The second via hole VIH2 may be formed by opening a portion of at least one insulating layer positioned between the connection pattern CNP and the second dummy electrode DME2. One area of the connection pattern CNP may be exposed through the second via hole VIH2.

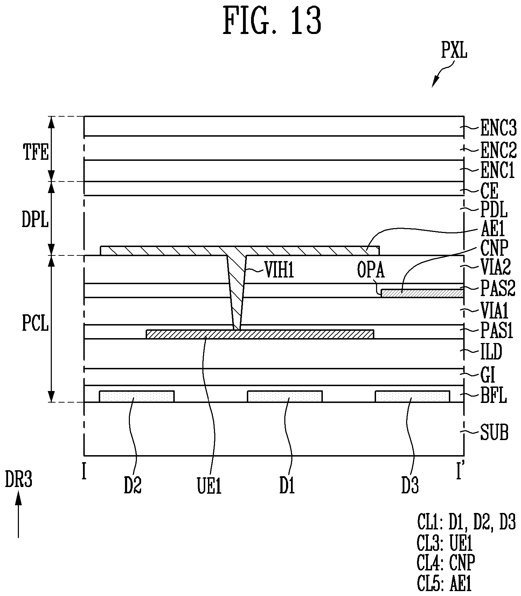

One area of the second dummy electrode DME2 may be exposed through a second opening OPN2 of the pixel defining layer PDL. The second opening OPN2 of the pixel defining layer PDL may be formed through a laser drilling process. A cathode electrode (refer to "CE" of FIG. 13) and the second dummy electrode DME2 may be electrically connected to each other through the second opening OPN2. According to some embodiments, the second dummy electrode DME2 may electrically connect the connection pattern CNP and the cathode electrode CE to each other. Because the dummy electrode DME including the second dummy electrode DME2 is electrically connected to the cathode electrode CE through the second opening OPN2 and is electrically connected to the connection pattern CNP through the second via hole VIH2, a voltage drop occurring on the cathode electrode CE may be prevented or reduced, whereby the reliability of the pixel PXL can be relatively enhanced.

Hereinafter, the following descriptions will be made with reference to FIGS. 13 to 16 centered on the stacked structure (or the cross-sectional structure) of the pixel PXL according to some embodiments.

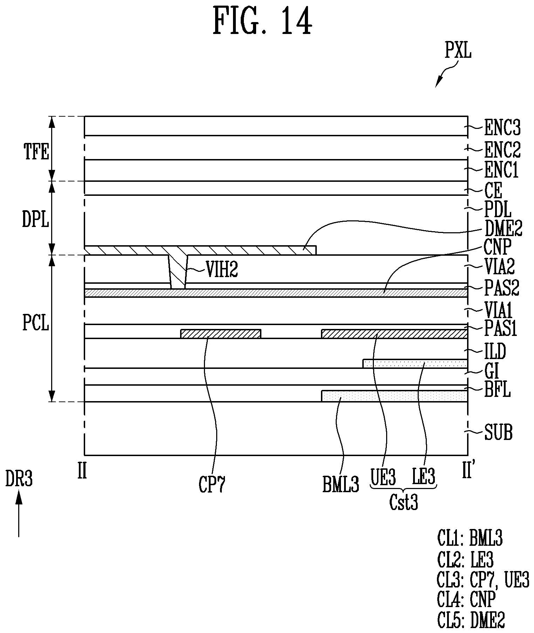

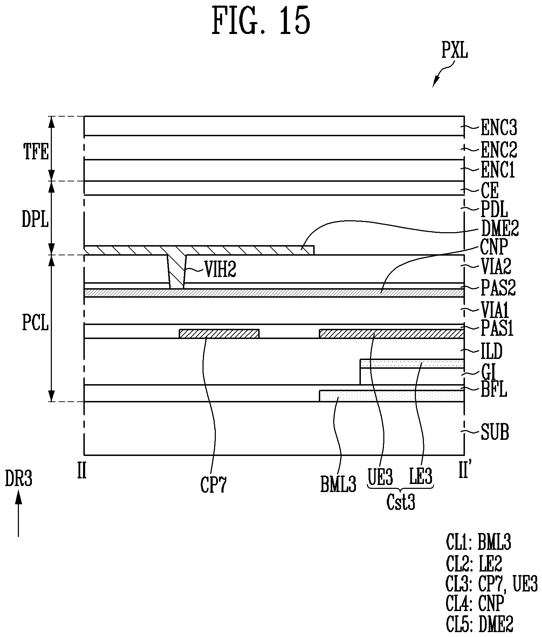

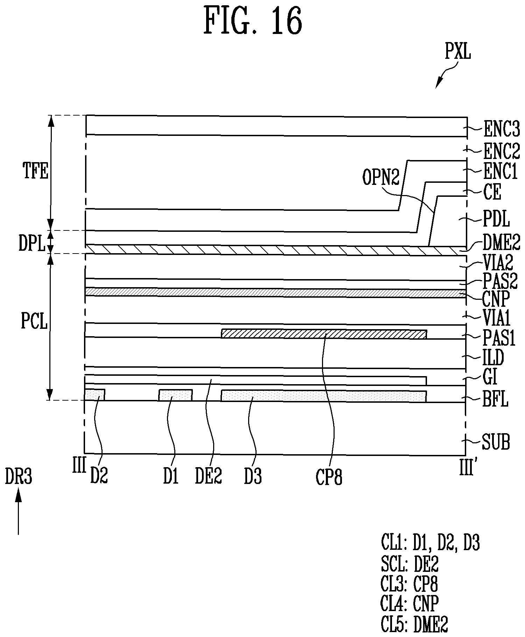

FIG. 13 is a schematic cross-sectional view taken along the line I-I' of FIG. 6. FIG. 14 and FIG. 15 are schematic cross-sectional views taken along the line II-II' of FIG. 6. FIG. 16 is a schematic cross-sectional view taken along the line III-III' of FIG. 6.

Although FIGS. 13 to 16 simply illustrate the stacked structure of the pixel PXL, e.g., illustrating that each electrode is formed of or comprise a single-layer electrode and each insulating layer is formed of or comprise a single insulating layer, embodiments of the present disclosure are not limited thereto.

The description of the embodiments of FIGS. 13 to 16 will be focused on differences from the above-mentioned embodiments so as to avoid redundant description.

Referring to FIGS. 6 to 16, the pixel PXL may include a first sub-pixel SPX1, a second sub-pixel SPX2, and a third sub-pixel SPX3 that are adjacent to each other.

Each of the first to third sub-pixels SPX1, SPX2, and SPX3 may include a substrate SUB, a pixel circuit layer PCL, a display element layer DPL, and an encapsulation layer TFE.

The substrate SUB may include transparent insulating material to allow light transmission. The substrate SUB may be a rigid substrate or a flexible substrate.

The first to third pixel circuits PXC1, PXC2, and PXC3, and the signal lines may be located in the pixel circuit layer PCL.

The light emitting element (refer to "LD" in FIG. 4) electrically connected to each of the first to third pixel circuits PXC1, PXC2, and PXC3 may be located in the display element layer DPL. For example, the first light emitting element (refer to "LD1" in FIG. 3) electrically connected to the first pixel circuit PXC1 may be located in the display element layer DPL of the first sub-pixel SPX1. The second light emitting element (refer to "LD2" in FIG. 3) electrically connected to the second pixel circuit PXC2 may be located in the display element layer DPL of the second sub-pixel SPX2. The third light emitting element (refer to "LD3" in FIG. 3) electrically connected to the third pixel circuit PXC3 may be located in the display element layer DPL of the third sub-pixel SPX3.

At least one or more insulating layers may be located on the substrate SUB. For example, sequentially stacked in a third direction DR3, a buffer layer BFL, a gate insulating layer GI, an interlayer insulating layer ILD, a first passivation layer PAS1, a first via layer VIA1, a second passivation layer PAS2, and a second via layer VIA2 may be located on the substrate SUB. Furthermore, at least one conductive layer may be located on the substrate SUB. For instance, the conductive layer may include a first conductive layer CL1, a second conductive layer CL2, a third conductive layer CL3, a fourth conductive layer CL4, and a fifth conductive layer CL5. The first conductive layer CL1 may be located between the substrate SUB and the buffer layer BFL. The second conductive layer CL2 may be located between the gate insulating layer GI and the interlayer insulating layer ILD. The third conductive layer CL3 may be located between the interlayer insulating layer ILD and the first passivation layer PAS1. The fourth conductive layer CL4 may be located between the first via layer VIA1 and the second passivation layer PAS2. The fifth conductive layer CL5 may be located on the second via layer VIA2.

The first conductive layer CL1 may include the first power line PL1, the initialization power line IPL, the first to third data lines D1 to D3, and the first to third bottom metal patterns BML1 to BML3. The second conductive layer CL2 may include the first to third lower electrodes LE1 to LE3, the first sub-scan line SSL1, and the first to third gate electrodes GE1 to GE3. The third conductive layer CL3 may include the first to third upper electrodes UE1 to UE3, the first to ninth conductive patterns CP1 to CP9, and the scan line SC. The fourth conductive layer CL4 may include the connection pattern CNP. The fifth conductive layer CL5 may include the first to third pixel electrodes AE1 to AE3, and the dummy electrode DME.

The pixel circuit layer PCL may be located on the substrate SUB. The buffer layer BFL, the gate insulating layer GI, the interlayer insulating layer ILD, the first passivation layer PAS1, the first via layer VIA1, the second passivation layer PAS2, and the second via layer VIA2 may be located in the pixel circuit layer PCL.

The buffer layer BFL may be located on the overall surface of the substrate SUB. The buffer layer BFL may prevent or reduce instances of impurities diffusing into the first to third transistors T1 to T3 included in the first to third pixel circuits PXC1 to PXC3. The buffer layer BFL may be an inorganic insulating layer including inorganic material. The buffer layer BFL may include at least one of silicon nitride (SiNₓ), silicon oxide (SiOₓ), silicon oxynitride (SiOₓN_{y}), or include at least one of metal oxides such as aluminum oxide (AlₓO_{y}). Although the buffer layer BFL may be provided in a single-layer structure, the buffer layer BFL may be provided in a multilayer structure having at least two or more layers. In the case where the buffer layer BFL has a multilayer structure, the respective layers may be formed of or comprise the same material or different materials. The buffer layer BFL may be omitted depending on the material of the substrate SUB or processing conditions.

The gate insulating layer GI may be located on the overall surface of the buffer layer BFL. The gate insulating layer GI may include the same material as that of the buffer layer BFL, or include suitable (or selected) material among the materials described as the constituent materials of the buffer layer BFL. For example, the gate insulating layer GI may include an inorganic insulating layer including inorganic material. According to some embodiments, the gate insulating layer GI may be partially located on the buffer layer BFL. For instance, the gate insulating layer GI may be etched along with the base material of the third lower electrode LE3 during a process of fabricating the third lower electrode LE3 such that, as illustrated in FIG. 15, the gate insulating layer GI is positioned only under the third lower electrode LE3 configured of the second conductive layer CL2. In this case, the gate insulating layer GI may have the same width as the third lower electrode LE3 positioned thereover, but embodiments of the present disclosure are not limited thereto.

The interlayer insulating layer ILD may be provided and/or formed on the overall surface of the gate insulating layer GI. The interlayer insulating layer ILD may include the same material as that of the buffer layer BFL, or include one or more suitable (or selected) materials among the materials described as the constituent materials of the buffer layer BFL. For example, the interlayer insulating layer ILD may be an inorganic insulating layer including inorganic material or an organic insulating layer including organic material.

The first passivation layer PAS1 may be provided and/or formed on the overall surface of the interlayer insulating layer ILD. The first passivation layer PAS1 may be an inorganic insulating layer including inorganic material.

The first via layer VIA1 may be provided and/or formed on the overall surface of the first passivation layer PAS1. The first via layer VIA1 may be formed of or comprise a single layer including an organic layer, or may be formed of or comprise multiple layers including two or more layers including an organic insulating layer. According to some embodiments, the first via layer VIA1 may be provided in a shape including an inorganic layer and an organic layer located on the inorganic layer. In the case where the first via layer VIA1 is provided in a multilayer structure including two or more layers, an organic layer that forms the first via layer VIA1 may be positioned in the uppermost layer. The first via layer VIA1 may include at least one of acrylic resin, epoxy resin, phenolic resin, polyamide resin, polyimide resin, unsaturated polyester resin, poly-phenylen ether resin, poly-phenylene sulfide resin, or benzocyclobutene resin.

The second passivation layer PAS2 may be provided and/or formed on the overall surface of the first via layer VIA1. The second passivation layer PAS2 may be an inorganic insulating layer including inorganic material.

The second via layer VIA2 may be provided and/or formed on the overall surface of the second passivation layer PAS2. The second via layer VIA2 may include the same material as that of the first via layer VIA1, or may include one or more suitable (or selected) materials among materials described as the constituent material of the first via layer VIA1. For example, the second via layer VIA2 may be formed of or comprise an organic insulating layer including organic material.

According to some embodiments, the second via layer VIA2, the second passivation layer PAS2, the first via layer VIA1, the first passivation layer PAS1 may include the first via holes VIH1 through which some respective configurations of the first to third pixel circuits PXC1 to PXC3 are exposed. For example, the second via layer VIA2, the second passivation layer PAS2, the first via layer VIA1, the first passivation layer PAS1 may include the first via hole VIH1 through which one area of the first upper electrode UE1 of the first pixel circuit PXC1 is exposed, the first via hole VIH1 through which one area of the second upper electrode UE2 of the second pixel circuit PXC2 is exposed, and the first via hole VIH1 through which one area of the third upper electrode UE3 of the third pixel circuit PXC3 is exposed.

Furthermore, according to some embodiments, the second via layer VIA2 and the second passivation layer PAS2 may include the second via hole VIH2 through which one area of the connection pattern CNP located in the pixel circuit layer PCL and formed of or comprise the fourth conductive layer CL4 is exposed.

On the buffer layer BFL of each of the first to third sub-pixels SPX1 to SPX3, there is located the corresponding pixel circuit. For example, the first pixel circuit PXC1 including the first to third transistors T1 to T3 and the first storage capacitor Cst1 may be located on the buffer layer BFL in the first sub-pixel SPX1. The second pixel circuit PXC2 including the first to third transistors T1 to T3 and the second storage capacitor Cst2 may be located on the buffer layer BFL in the second sub-pixel SPX2. The third pixel circuit PXC3 including the first to third transistors T1 to T3 and the third storage capacitor Cst3 may be located on the buffer layer BFL in the third sub-pixel SPX3.

The first transistor T1 may include a first active pattern ACT1, a first source electrode SE1, and a first drain electrode DE1 which are located on the buffer layer BFL, and a first gate electrode GE1 located on the gate insulating layer GI. A bottom metal pattern corresponding to lower portions of the first gate electrode GE1 and the first active pattern ACT1 may be arranged with the buffer layer BFL interposed therebetween. For example, in the first sub-pixel SPX1, the first bottom metal pattern BML1 may be located under the first gate electrode GE1 and the first active pattern ACT1 with the buffer layer BFL interposed therebetween. In the second sub-pixel SPX2, the second bottom metal pattern BML2 may be located under the first gate electrode GE1 and the first active pattern ACT1 with the buffer layer BFL interposed therebetween. In the third sub-pixel SPX3, the third bottom metal pattern BML3 may be located under the first gate electrode GE1 and the first active pattern ACT1 with the buffer layer BFL interposed therebetween.

The second transistor T2 may include a second active pattern ACT2, a second source electrode SE2, and a second drain electrode DE2 which are located on the buffer layer BFL, and a second gate electrode GE2 located on the gate insulating layer GI.

The third transistor T3 may include a third active pattern ACT3, a third source electrode SE3, and a third drain electrode DE3 which are located on the buffer layer BFL, and a third gate electrode GE3 located on the gate insulating layer GI.

The first storage capacitor Cst1 may include a first lower electrode LE1 located between the gate insulating layer GI and the interlayer insulating layer ILD, and a first upper electrode UE1 located between the interlayer insulating layer ILD and the first passivation layer PAS1. The first upper electrode UE1 may be electrically connected to the first pixel electrode AE1 through the corresponding first via hole VIH1. In a cross-sectional view, the first pixel electrode AE1 may be located on the first upper electrode UE1 with the first via hole VIH1 formed therebetween.

The second storage capacitor Cst2 may include a second lower electrode LE2 located between the gate insulating layer GI and the interlayer insulating layer ILD, and a second upper electrode UE2 located between the interlayer insulating layer ILD and the first passivation layer PAS1. The second upper electrode UE2 may be electrically connected to the second pixel electrode AE2 through the corresponding first via hole VIH1. In a cross-sectional view, the second pixel electrode AE2 may be located on the second upper electrode UE2 with the first via hole VIH1 formed therebetween.

The third storage capacitor Cst3 may include a third lower electrode LE3 located between the gate insulating layer GI and the interlayer insulating layer ILD, and a third upper electrode UE3 located between the interlayer insulating layer ILD and the first passivation layer PAS1. The third upper electrode UE3 may be electrically connected to the third pixel electrode AE3 through the corresponding first via hole VIH1. In a cross-sectional view, the third pixel electrode AE3 may be located on the third upper electrode UE3 with the first via hole VIH1 formed therebetween.

The display element layer DPL may be provided and/or formed on the second via layer VIA2 of the pixel circuit layer PCL.

The display element layer DPL may include the first light emitting element LD1, the second light emitting element LD2, the third light emitting element LD3, and the pixel defining layer PDL. The first light emitting element LD1 may be located in the display element layer DPL of the first sub-pixel SPX1, and may be electrically connected to the first pixel circuit PXC1. The second light emitting element LD2 may be located in the display element layer DPL of the second sub-pixel SPX2, and may be electrically connected to the second pixel circuit PXC2. The third light emitting element LD3 may be located in the display element layer DPL of the third sub-pixel SPX3, and may be electrically connected to the third pixel circuit PXC3.

The first light emitting element LD1 may include a first pixel electrode AE1, a first emission layer EML1, and a cathode electrode CE. The second light emitting element LD2 may include a second pixel electrode AE2, a second emission layer EML2, and a cathode electrode CE. The third light emitting element LD3 may include a third pixel electrode AE3, a third emission layer EML3, and a cathode electrode CE.

The first pixel electrode AE1, the second pixel electrode AE2, and the third pixel electrode AE3 may be formed of or comprise the fifth conductive layer CL5 provided and/or formed on the second via layer VIA2 in the corresponding sub-pixel. The first pixel electrode AE1, the second pixel electrode AE2, and the third pixel electrode AE3 may be located on the second via layer VIA2 (or the pixel circuit layer PCL) and apart from each other. The first pixel electrode AE1 may be an anode electrode of the first light emitting element LD1. The second pixel electrode AE2 may be an anode electrode of the second light emitting element LD2. The third pixel electrode AE3 may be an anode electrode of the third light emitting element LD3.

The first pixel electrode AE1 may be electrically connected to the first upper electrode UE1 of the first storage capacitor Cst1 through the first via hole VIH1 that passes through the second via layer VIA2, the second passivation layer PAS2, the first via layer VIA1, and the first passivation layer PAS1 simultaneously (or at one time).

The second pixel electrode AE2 may be electrically connected to the second upper electrode UE2 of the second storage capacitor Cst2 through the first via hole VIH1 that passes through the second via layer VIA2, the second passivation layer PAS2, the first via layer VIA1, and the first passivation layer PAS1 simultaneously (or at one time).

The third pixel electrode AE3 may be electrically connected to the third upper electrode UE3 of the third storage capacitor Cst3 through the first via hole VIH1 that passes through the second via layer VIA2, the second passivation layer PAS2, the first via layer VIA1, and the first passivation layer PAS1 simultaneously (or at one time).

Each of the first pixel electrode AE1, the second pixel electrode AE2, and the third pixel electrode AE3 may be formed of or comprise conductive material (or substance). The conductive material may include opaque metal. For example, the opaque metal may include metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and an alloy thereof. The material of each of the first pixel electrode AE1, the second pixel electrode AE2, and the third pixel electrode AE3 are not limited to those of the aforementioned embodiments. According to some embodiments, each of the first pixel electrode AE1, the second pixel electrode AE2, and the third pixel electrode AE3 may include transparent conductive material (or substance). The transparent conductive material (or substance) may include transparent conductive oxides such as indium tin oxide (ITO), indium zinc oxide (IZO), zinc oxide (ZnOₓ), indium gallium zinc oxide (IGZO), and indium tin zinc oxide (ITZO), and a conductive polymer such as PEDOT (poly(3,4-ethylenedioxythiophene)).

The first pixel electrode AE1 may be positioned in at least the first emission area (refer to "EMA1" of FIG. 3). The second pixel electrode AE2 may be positioned in at least the second emission area (refer to "EMA2" of FIG. 3). The third pixel electrode AE3 may be positioned in at least the third emission area (refer to "EMA3" of FIG. 3).

According to some embodiments, the dummy electrode DME spaced apart from the first to third pixel electrodes AE1 to AE3 may be located on the second via layer VIA2 (or the pixel circuit layer PCL). The dummy electrode DME may be positioned in the same layer as the first to third pixel electrodes AE1 to AE3 and may include the same material. The dummy electrode DME may be positioned in the non-emission area (refer to "NEA" of FIG. 3). The dummy electrode DME may include a first dummy electrode DME1 and a second dummy electrode DME2.

The second dummy electrode DME2 may be electrically connected to the connection pattern CNP through the second via hole VIH2 that passes through the second via layer VIA2 and the second passivation layer PAS2 simultaneously (or at one time).

The pixel defining layer PDL may define (or partition) the first emission area EMA1, the second emission area EMA2, and the third emission area EMA3. The pixel-defining layer PDL may include an organic insulating layer made of an organic material. The organic material may include acryl resin, epoxy resin, phenolic resin, polyamide resin, polyimide resin, or the like. According to some embodiments, the pixel defining layer PDL may include light absorbing material or be coated with light absorbent, so that the pixel defining layer PDL can function to absorb light introduced from the outside. For example, the pixel defining layer PDL may include carbon-based black pigment, but is not limited thereto.

The pixel defining layer PDL may be partially open to include the first openings OPN1 that expose respective areas of the first pixel electrode AE1, the second pixel electrode AE2, and the third pixel electrode AE3, and may protrude from the second via layer VIA2 (or the pixel circuit layer PCL) along a periphery of each of the first to third emission areas EMA1, EMA2, and EMA3 in the third direction DR3.

Furthermore, the pixel defining layer PDL may include the second opening OPN2 through which one area of the second dummy electrode DME2 is exposed. The second opening OPN2 may be a connection point at which the second dummy electrode DME2 and the cathode electrode CE are electrically connected to each other.

The first emission layer (refer to "EML1" of FIG. 12) may be located on the first pixel electrode AE1 that is exposed through one of the first openings OPN1 of the pixel defining layer PDL. The second emission layer (refer to "EML2" of FIG. 12) may be located on the second pixel electrode AE2 that is exposed through another one of the first openings OPN1 of the pixel defining layer PDL. The third emission layer (refer to "EML3" of FIG. 12) may be located on the third pixel electrode AE3 that is exposed through another one of the first openings OPN1 of the pixel defining layer PDL.

The first emission layer EML1 may be located on only the first pixel electrode AE1 in the corresponding first opening OPN1 of the pixel defining layer PDL. The second emission layer EML2 may be located on only the second pixel electrode AE2 in the corresponding first opening OPN1 of the pixel defining layer PDL. The third emission layer EML3 may be located on only the third pixel electrode AE3 in the corresponding first opening OPN1 of the pixel defining layer PDL. Each of the first emission layer EML1, the second emission layer EML2, and the third emission layer EML3 may be supplied to a target area of the corresponding sub-pixel (e.g., onto one area of the corresponding pixel electrode that is exposed through the corresponding first opening OPN1 of the pixel defining layer PDL) by an inkjet printing method or the like, but embodiments of the present disclosure are not limited thereto.

Each of the first emission layer EML1, the second emission layer EML2, and the third emission layer EML3 may have a multilayer thin-film structure including a light generation layer configured to generate light. For example, the first emission layer EML1 may include a light generation layer configured to generate and emit red light. The second emission layer EML2 may include a light generation layer configured to generate and emit green light. The third emission layer EML3 may include a light generation layer configured to generate and emit blue light. However, embodiments of the present disclosure are not limited to the aforementioned example. According to some embodiments, each of the first emission layer EML1, the second emission layer EML2, and the third emission layer EML3 may include a light generation layer configured to generate and emit white light. In this case, there may be provided a color conversion layer or the like to convert the white light (or light of a first color) into light of a specific color (or light of a second light).

The cathode electrode CE may be provided and/or formed on the first emission layer EML1, the second emission layer EML2, the third emission layer EML3, and the pixel defining layer PDL.

The cathode electrode CE (referred to as "second electrode" or "cathode electrode") may be a common layer provided in common to the first sub-pixel SPX1, the second sub-pixel SPX2, and the third sub-pixel SPX3. The cathode electrode CE may be provided in the form of a plate in the overall area of the display area DA, but is not limited thereto.

The cathode electrode CE may be a thin-film metal layer having a thickness sufficient to allow transmission of light emitted from each of the first emission layer EML1, the second emission layer EML2, and the third emission layer EML3. The cathode electrode CE may be formed of or comprise a metal material having a relatively small thickness, or a transparent conductive material. According to some embodiments, the cathode electrode CE may be formed of or comprise various transparent conductive materials. The cathode electrode CE may include at least one of various transparent conductive materials including indium tin oxide, indium zinc oxide, indium tin zinc oxide, aluminum zinc oxide, gallium zinc oxide, zinc tin oxide, or gallium tin oxide, and may be transparent or translucent (or substantially transparent or translucent) to provide satisfactory transmittance. Hence, light emitted from each of the first to third emission layers EML1, EML2, and EML3 that are positioned under the cathode electrode CE may pass through the cathode electrode CE and be emitted in the upward direction of the encapsulation layer TFE.

The cathode electrode CE may be electrically connected to the second dummy electrode DME2 formed of or comprise the fifth conductive layer CL5, through the second opening OPN2 of the pixel defining layer PDL.

The encapsulation layer TFE may be provided and/or formed on the overall surface of the cathode electrode CE.

The encapsulation layer TFE may include a first encapsulation layer ENC1, a second encapsulation layer ENC2, and a third encapsulation layer ENC3 that are sequentially positioned on the cathode electrode CE. The first encapsulation layer ENC1 may be located on the display element layer DPL (or the cathode electrode CE), and positioned over the display area DA and at least a portion of the non-display area NDA. The second encapsulation layer ENC2 may be formed on the first encapsulation layer ENC1, and positioned over the display area DA and at least a portion of the non-display area NDA. The third encapsulation layer ENC3 may be formed on the second encapsulation layer ENC2, and positioned over the display area DA and at least a portion of the non-display area NDA. According to some embodiments, the third encapsulation layer ENC3 may be positioned over the display area DA and the entirety of the non-display area NDA.

Each of the first and third encapsulation layers ENC1 and ENC3 may be formed of or comprise an inorganic layer including inorganic material. The second encapsulation layer ENC2 may be formed of or comprise an organic layer including organic material. The inorganic layer may include, for example, silicon nitride (SiNₓ), silicon oxide (SiOₓ), or silicon oxynitride (SiOₓN_{y}). The organic layer may include organic insulating material such as polyacrylate resin, epoxy resin, phenolic resin, polyamide resin, polyimide resin, unsaturated polyester resin, polyphenylene resin, polyphenylene sulfide resin, or benzocyclobutene (BCB).

According to some embodiments, a color filter layer and/or a color conversion layer configured to emit light generated from the first to third light emitting elements LD1, LD2, and LD3 as light having excellent color reproducibility may be selectively provided and/or formed on the encapsulation layer TFE.

According to some embodiments, the connection pattern CNP formed of or comprise the fourth conductive layer CL4 may be designed in a shape bypassing the first via hole VIH1 of each of the first to third sub-pixels SPX1 to SPX3, the fourth conductive layer CL4 may not be positioned around the first via hole VIH1. In other words, the fourth conductive layer CL4 may not be positioned at the second node (refer to "N2" of FIG. 4) that is a connection point at which each of the first to third pixel circuits PXC1 to PXC3 and the corresponding light emitting element (refer to "LD" of FIG. 4) are electrically connected to each other. In this case, other conductive layers may not be respectively positioned between the first upper electrode UE1 and the first pixel electrode AE1 that are positioned at the second node N2, between the second upper electrode UE2 and the second pixel electrode AE2, and between the third upper electrode UE3 and the third pixel electrode AE3.

In the first sub-pixel SPX1, the first via hole VIH1 through which one area of the first upper electrode UE1 is exposed may be formed by simultaneously (or at one time) etching the first passivation layer PAS1, the first via layer VIA1, the second passivation layer PAS2, and the second via layer VIA2 that are formed on the first upper electrode UE1 before the first pixel electrode AE1 is formed. The first pixel electrode AE1 may directly contact the first upper electrode UE1 through the first via hole VIH1, thus being electrically connected to the first upper electrode UE1. As described above, because the first pixel electrode AE1 formed of or comprise the fifth conductive layer CL5 and the first upper electrode UE1 formed of or comprise the third conductive layer CL3 are directly electrically connected to each other through the corresponding first via hole VIH1, a separate first bridge pattern (or first intermediate conductive pattern) formed of or comprise the fourth conductive layer CL4 and positioned between the first upper electrode UE1 and the first pixel electrode AE1 to electrically connect the first upper electrode UE1 and the first pixel electrode AE1 to each other may be omitted. If the first bridge pattern is omitted, a process of forming a first contactor (or a first contact hole) for connecting the first bridge pattern and the first upper electrode UE1 and a second contactor (or a second contact hole) for connecting the first bridge pattern and the first pixel electrode AE1 may be skipped. Consequently, the number of mask processes with regard to the first sub-pixel SPX1 can be reduced, whereby the fabrication efficiency of the display device (refer to "DD" of FIG. 1) may be enhanced. Furthermore, the first contactor and the second contactor may be omitted, so that mounting space for the circuit elements in the pixel area (refer to "PXA" of FIG. 6) can be further secured.

In the second sub-pixel SPX2, the first via hole VIH1 through which one area of the second upper electrode UE2 is exposed may be formed by simultaneously (or at one time) etching the first passivation layer PAS1, the first via layer VIA1, the second passivation layer PAS2, and the second via layer VIA2 that are formed on the second upper electrode UE2 before the second pixel electrode AE2 is formed. The second pixel electrode AE2 may directly contact the second upper electrode UE2 through the first via hole VIH1, thus being electrically connected to the second upper electrode UE2. As described above, because the second pixel electrode AE2 formed of or comprise the fifth conductive layer CL5 and the second upper electrode UE2 formed of or comprise the third conductive layer CL3 are directly electrically connected to each other through the corresponding first via hole VIH1, a separate second bridge pattern (or second intermediate conductive pattern) formed of or comprise the fourth conductive layer CL4 and positioned between the second upper electrode UE2 and the second pixel electrode AE2 to electrically connect the second upper electrode UE2 and the second pixel electrode AE2 to each other may be omitted. If the second bridge pattern is omitted, a process of forming a first contactor (or a first contact hole) for connecting the second bridge pattern and the second upper electrode UE2 and a second contactor (or a second contact hole) for connecting the second bridge pattern and the second pixel electrode AE2 may be skipped. Consequently, the number of mask processes with regard to the second sub-pixel SPX2 can be reduced, whereby the fabrication efficiency of the display device DD may be enhanced. Furthermore, the first contactor and the second contactor may be omitted, so that mounting space for the circuit elements in the pixel area PXA can be further secured.

In the third sub-pixel SPX3, the first via hole VIH1 through which one area of the third upper electrode UE3 is exposed may be formed by simultaneously (or at one time) etching the first passivation layer PAS1, the first via layer VIA1, the second passivation layer PAS2, and the second via layer VIA2 that are formed on the third upper electrode UE3 before the third pixel electrode AE3 is formed. The third pixel electrode AE3 may directly contact the third upper electrode UE3 through the first via hole VIH1, thus being electrically connected to the third upper electrode UE3. As described above, because the third pixel electrode AE3 formed of or comprise the fifth conductive layer CL5 and the third upper electrode UE3 formed of or comprise the third conductive layer CL3 are directly electrically connected to each other through the corresponding first via hole VIH1, a separate third bridge pattern (or third intermediate conductive pattern) formed of or comprise the fourth conductive layer CL4 and positioned between the third upper electrode UE3 and the third pixel electrode AE3 to electrically connect the third upper electrode UE3 and the third pixel electrode AE3 to each other may be omitted. If the third bridge pattern is omitted, a process of forming a first contactor (or a first contact hole) for connecting the third bridge pattern and the third upper electrode UE3 and a second contactor (or a second contact hole) for connecting the third bridge pattern and the third pixel electrode AE3 may be skipped. Consequently, the number of mask processes with regard to the third sub-pixel SPX3 can be reduced, whereby the fabrication efficiency of the display device DD may be enhanced. Furthermore, the first contactor and the second contactor may be omitted, so that mounting space for the circuit elements in the pixel area PXA can be further secured.

According to some embodiments, the cathode electrode CE, the second dummy electrode DME2, and the connection pattern CNP that are positioned in different layers are electrically connected to each other. Hence, instances of a voltage drop of the cathode electrode CE may be prevented or reduced.

According to some embodiments, the connection pattern CNP formed of or comprise the fourth conductive layer CL4 may be electrically connected, through the second via hole VIH2, to the dummy electrode DME positioned over the connection pattern CNP, and may not be electrically connected to the conductive layers positioned under the connection pattern CNP. In this case, a process of forming the contactor for electrically connecting the connection pattern CNP and components positioned under the connection pattern CNP may be omitted, whereby the fabrication efficiency of the display device DD can be further enhanced.

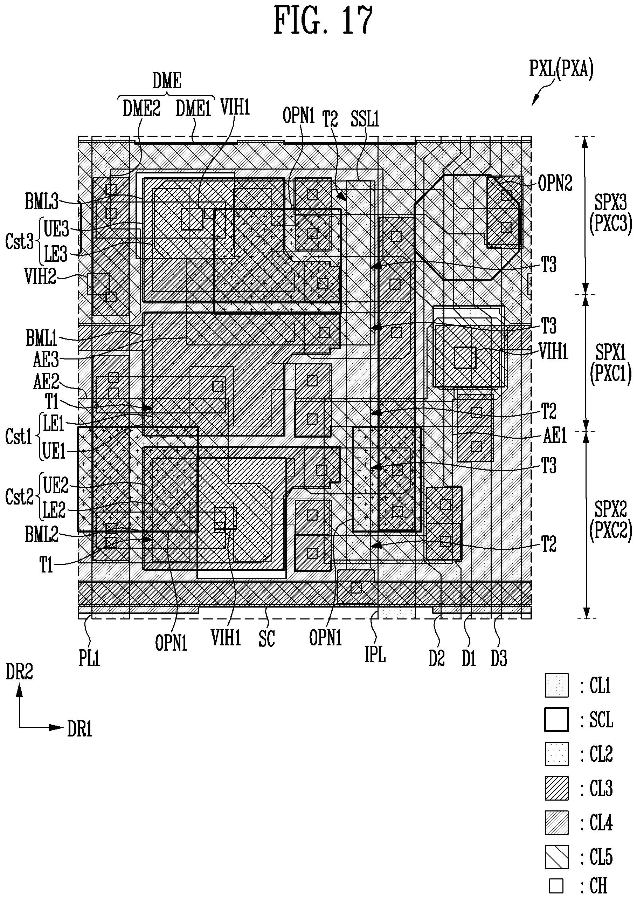

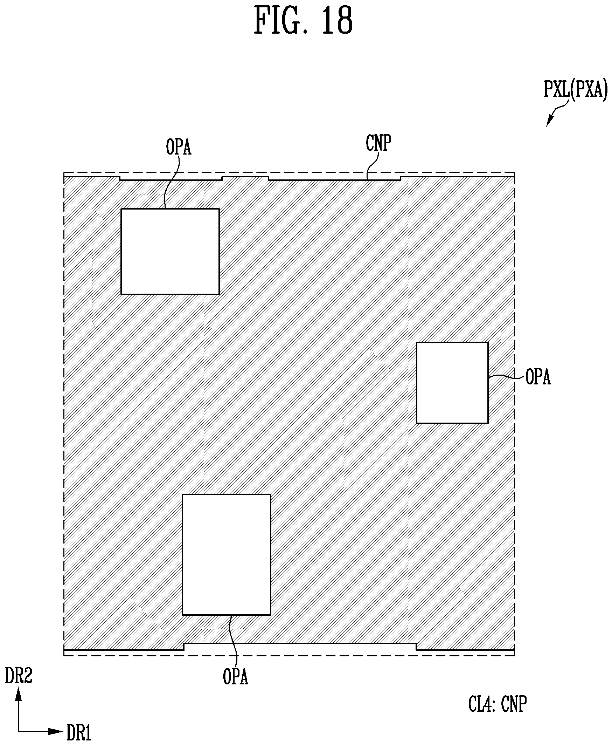

FIG. 17 is a schematic plan view illustrating a pixel PXL according to some embodiments. FIG. 18 is a schematic plan view illustrating only components included in a fourth conductive layer CL4 in the pixel PXL of FIG. 17.

The embodiments of FIGS. 17 and 18 refer to a modified example of FIGS. 6 and 10 with regard to the shape or the like of the connection pattern CNP.

The description of the embodiments of FIGS. 17 and 18 will be focused on differences from the above-mentioned embodiments so as to avoid redundant description.

Referring to FIGS. 17 and 18, the connection pattern CNP formed of or comprise the fourth conductive layer CL4 may be positioned in the pixel area PXA.

The connection pattern CNP may include an opening area OPA formed by removing a portion thereof. The opening area OPA may correspond to a first via hole VIH1 in each of the first to third sub-pixels SPX1 to SPX3. For example, the connection pattern CNP may include three opening areas OPA. The opening areas OPA may correspond to the first via hole VIH1 in the first sub-pixel SPX1, the first via hole VIH1 in the second sub-pixel SPX2, and the first via hole VIH1 in the third sub-pixel SPX3.

The opening area OPA may have a closed-loop shape in a plan view, but is not limited thereto. According to some embodiments, the opening area OPA may be open on at least one area thereof.

The connection pattern CNP may not be positioned around the first via hole VIH1 in each of the first to third sub-pixels SPX1 to SPX3. Consequently, in the first sub-pixel SPX1, the first pixel electrode AE1 may be electrically connected to the first upper electrode UE1 through the corresponding first via hole VIH1. In the second sub-pixel SPX2, the second pixel electrode AE2 may be electrically connected to the second upper electrode UE2 through the corresponding first via hole VIH1. In the third sub-pixel SPX3, the third pixel electrode AE3 may be electrically connected to the third upper electrode UE3 through the corresponding first via hole VIH1.

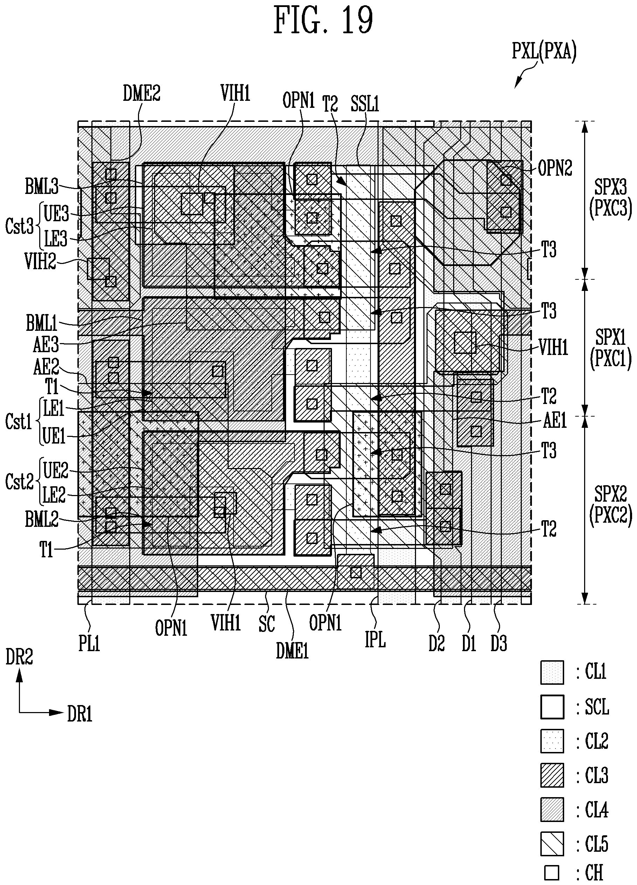

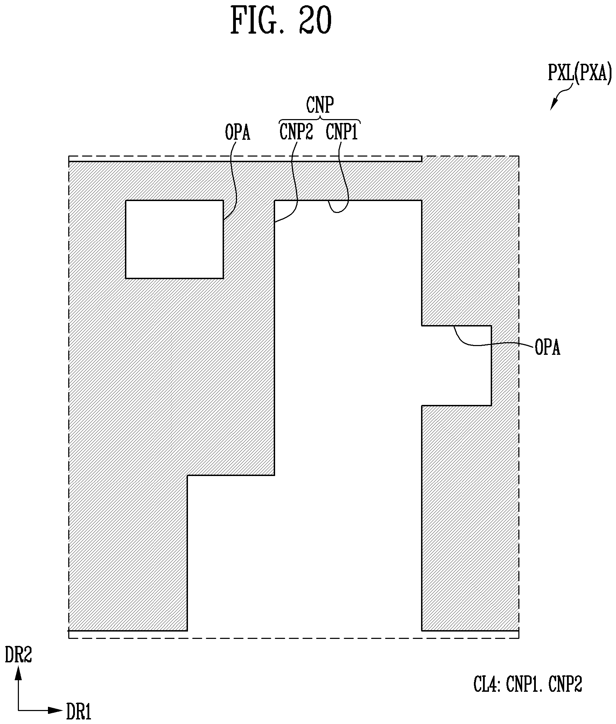

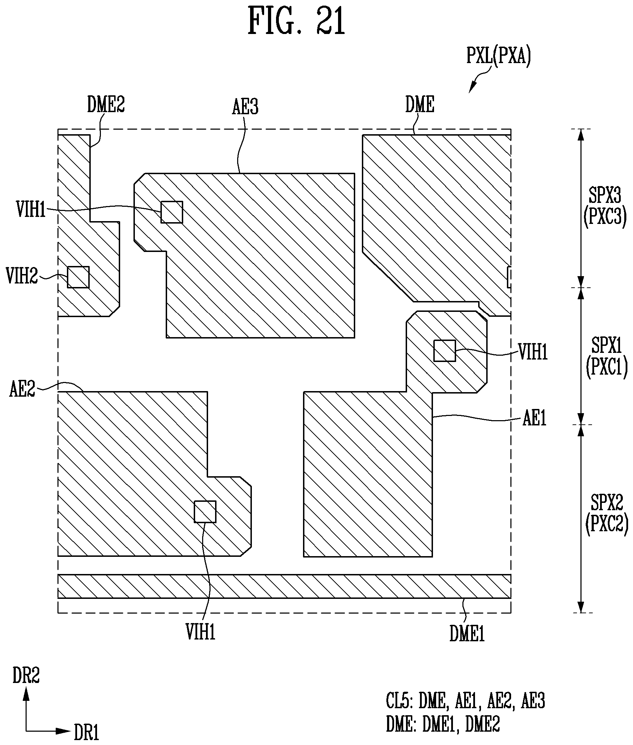

FIG. 19 is a schematic plan view illustrating a pixel PXL according to some embodiments. FIG. 20 is a schematic plan view illustrating only components included in a fourth conductive layer CL4 in the pixel PXL of FIG. 19. FIG. 21 is a schematic plan view illustrating only components included in a fifth conductive layer CL5 in the pixel PXL of FIG. 19.

The embodiments of FIGS. 19 to 21 refers to a modified example of FIGS. 6, 10, and 11 with regard to the shapes or the like of the connection pattern CNP and the dummy electrode DME.

The description of the embodiments of FIGS. 19 to 21 will be focused on differences from the above-mentioned embodiments so as to avoid redundant description.

Referring to FIGS. 19 to 21, the connection pattern CNP formed of or comprise the fourth conductive layer CL4 may be positioned in the pixel area PXA.

The connection pattern CNP may include a first connection pattern CNP1 extending in the first direction DR1, and a second connection pattern CNP2 extending in the second direction DR2. The first connection pattern CNP1 and the second connection pattern CNP2 may be integrally formed and connected to each other. Due to the first connection pattern CNP1 and the second connection pattern CNP2 connected to each other, the connection pattern CNP may have a mesh structure.

The connection pattern CNP may have a shape bypassing the first via hole VIH1 positioned at the second node (refer to "N2" of FIG. 4) of each of the first to third sub-pixels SPX1 to SPX3. For example, the connection pattern CNP may have a shape including an opening area OPA corresponding to the first via hole VIH1 positioned at the second node N2 in each of the first to third sub-pixels SPX1 to SPX3. The opening area OPA may have a closed-loop shape or a shape in which one area is open.

The connection pattern CNP may not be positioned around the first via hole VIH1 in each of the first to third sub-pixels SPX1 to SPX3. Consequently, in the first sub-pixel SPX1, the first pixel electrode AE1 may directly contact the first upper electrode UE1 through the corresponding first via hole VIH1 and thus be electrically connected to the first upper electrode UE1. In the second sub-pixel SPX2, the second pixel electrode AE2 may directly contact the second upper electrode UE2 through the corresponding first via hole VIH1 and thus be electrically connected to the second upper electrode UE2. In the third sub-pixel SPX3, the third pixel electrode AE3 may directly contact the third upper electrode UE3 through the corresponding first via hole VIH1 and thus be electrically connected to the third upper electrode UE3.

According to some embodiments, the first to third pixel electrodes AE1 to AE3 and the dummy electrode DME, which are formed of or comprise the fifth conductive layer CL5, may be located in the pixel area PXA. The dummy electrode DME may include a first dummy electrode DME1 and a second dummy electrode DME2. The first pixel electrode AE1, the second pixel electrode AE2, the third pixel electrode AE3, the first dummy electrode DME1, and the second dummy electrode DME2 may be spaced apart from each other.

The first dummy electrode DME1 may extend in the first direction DR1. The second dummy electrode DME2 may extend in the second direction DR2. The first dummy electrode DME1 and the second dummy electrode DME2 may be spaced apart from each other and thus be electrically separated from each other.

According to some embodiments, the second dummy electrode DME2 may be electrically connected to the connection pattern CNP through the second via hole VIH2. Furthermore, the second dummy electrode DME2 may be electrically connected to the cathode electrode (refer to "CE" of FIG. 13) through the second opening OPN2 of the pixel defining layer (refer to "PDL" of FIG. 12).

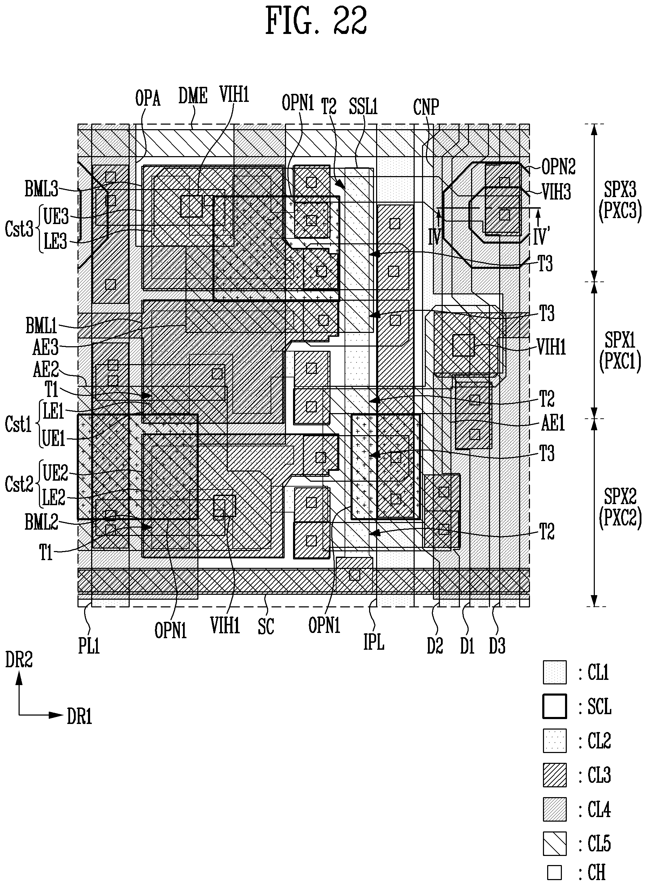

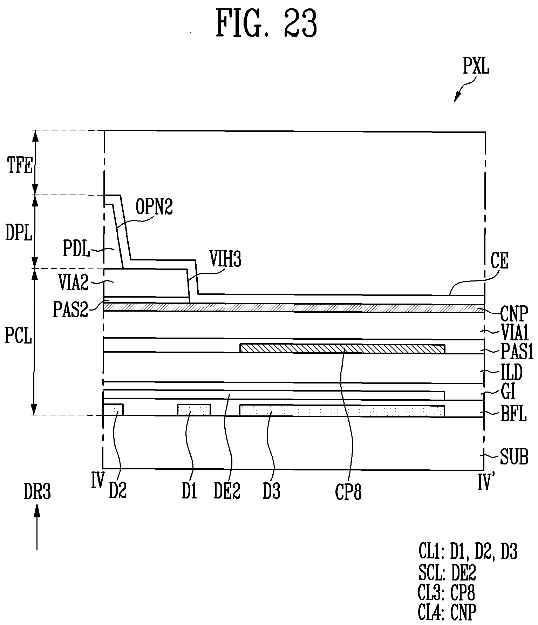

FIG. 22 is a schematic plan view illustrating a pixel PXL according to some embodiments. FIG. 23 is a schematic cross-sectional view taken along the line IV-IV' of FIG. 22.

The embodiments of FIGS. 22 and 23 refers to a modified example of FIGS. 6, and 16 with regard to the shapes or the like of the connection pattern CNP and the dummy electrode DME.

The description of the embodiments of FIGS. 22 and 23 will be focused on differences from the above-mentioned embodiments so as to avoid redundant description.

Referring to FIGS. 22 and 23, the connection pattern CNP formed of or comprise the fourth conductive layer CL4 may be positioned in the pixel area PXA. Furthermore, the dummy electrode DME, which is formed of or comprise the fifth conductive layer CL5 and spaced apart from the first to third pixel electrodes AE1 to AE3, may be located in the pixel area PXA.

According to some embodiments, the dummy electrode DME may extend in the first direction DR1 and be positioned in each of an upper portion and a lower portion of the pixel area PXA in a plan view. The dummy electrode DME may float rather than being electrically connected to the components of the first to third sub-pixels SPX1 to SPX3 {e.g., the pixel circuit (refer to "PXC" of FIG. 4) and the light emitting element (refer to "LD" of FIG. 4)}. For example, the dummy electrode DME may be a floating pattern. In this case, the dummy electrode DME may be omitted.

According to some embodiments, the connection pattern CNP may have a shape bypassing the second node (refer to "N2" of FIG. 4) at which the first via hole VIH1 is positioned, in each of the first to third sub-pixels SPX1 to SPX3. The connection pattern CNP may have a shape including an opening area OPA corresponding to the first via hole VIH1.

The connection pattern CNP may be electrically connected to the cathode electrode CE of the display element layer DPL through a third via hole VIH3 and a second opening OPN2 of the pixel defining layer PDL. The third via hole VIH3 may be formed by removing portions of the second passivation layer PAS2 and the second via layer VIA2 that are positioned on the connection pattern CNP, and expose one area of the connection pattern CNP to the outside. The second opening OPN2 may be formed by removing a portion of the pixel defining layer PDL, and expose one area of the second via layer VIA2 to the outside.

The third via hole VIH3 may correspond to the second opening OPN2 of the pixel defining layer PDL. In a plan view, the third via hole VIH3 and the second opening OPN2 of the pixel defining layer PDL may overlap each other. The fifth conductive layer CL5 may not be positioned around the third via hole VIH3 and the second opening OPN2. In other words, no other conductive layer may be positioned around the third via hole VIH3 and the seconding opening OPN2 between the connection pattern CNP and the cathode electrode CE. Consequently, the cathode electrode CE may directly contact the connection pattern CNP through the third via hole VIH3 and the second opening OPN2 and thus be electrically connected to the connection pattern CNP. As described above, in the case where the cathode electrode CE and the connection pattern CNP are directly electrically connected to each other through the third via hole VIH3 and the second opening OPN2, a separate conductive pattern configured to connect the cathode electrode CE and the connection pattern CNP, for example, the second electrode DME described with reference to FIG. 6, may be omitted.

As discussed, embodiments can provide a display device, comprising: a substrate; a first conductive layer, a second conductive layer, a third conductive layer, a fourth conductive layer, and a fifth conductive layer sequentially stacked on the substrate; a transistor on the substrate; a conductive pattern on the transistor, and electrically connected to the transistor, and comprising the third conductive layer; an insulating layer on the conductive pattern and including a first via hole exposing one area of the conductive pattern; a light emitting element on the insulating layer, and electrically connected to the conductive pattern through the first via hole; and a connection pattern between the conductive pattern and the light emitting element, and comprising the fourth conductive layer, wherein the connection pattern does not overlap the first via hole.

The light emitting element may be connected between a first power line configured to receive a first power voltage and a second power line configured to receive a second power voltage. A first electrode (e.g., "pixel electrode" or "anode electrode") may be connected to the first power voltage (or first power supply) and the first power line, and a second electrode (e.g., "common electrode" or "cathode electrode") may be connected to the second power voltage (or second power supply) via the second power line. The connection pattern may be electrically connected to the second power line.

The light emitting element may be part of a pixel circuit.

The pixel circuit may include first, second, and third transistors, and a storage capacitor.

The first transistor may be a driving transistor configured to control driving current to be applied to the light emitting element and be electrically connected between the first power supply and the light emitting element. In detail, a first terminal of the first transistor may be electrically connected to the first power supply by the first power line. A second terminal of the first transistor may be electrically connected to a second node. A gate electrode of the first transistor may be electrically connected to a first node.

The second transistor may be a switching transistor configured to select a pixel in response to a scan signal and activate the pixel, and may be electrically connected between a data line and the first node. A first terminal of the second transistor may be electrically connected to the data line. A second terminal of the second transistor may be electrically connected to the first node (or the gate electrode of the first transistor). A gate electrode of the second transistor may be electrically connected to a scan line.

The third transistor may acquire a sensing signal through a sensing line by electrically connecting the first transistor to the sensing line, and may detect, using the sensing signal, characteristics of the pixel such as a threshold voltage of the first transistor. The third transistor may be an initialization transistor configured to initialize the second node, and may be turned on in case that a sensing control signal is supplied thereto from a control line, thus transmitting an initialization voltage to the second node.

The storage capacitor may include a lower electrode (or a first storage electrode) and an upper electrode (or a second storage electrode). The lower electrode may be electrically connected to the first node. The upper electrode may be electrically connected to the second node.

The data lines may be formed of or comprise the first conductive layer.

A gate electrode may be formed of or comprise the second conductive layer.

The scan lines may be formed of or comprise the third conductive layer.

The pixel electrode (which may be referred to as "first electrode" or "anode electrode") may be formed of or comprise the fifth conductive layer.

The upper electrode may be arranged to overlap the lower electrode in a plan view, and have a size (or a surface area) greater than the lower electrode, but embodiments of the present disclosure is are not limited thereto. The upper electrode may be formed of or comprise the third conductive layer.

The upper electrode may be electrically connected to the pixel electrode through a corresponding first via hole. The first via hole may be formed by opening a portion of at least one insulating layer positioned between the first upper electrode and the first pixel electrode. One area of the first upper electrode may be exposed through the first via hole. The first via hole may be positioned at the second node that is a connection point at which the pixel circuit and the light emitting element are electrically connected to each other. For example, a point at which the upper electrode of the pixel circuit and the pixel electrode of the light emitting element are electrically connected to each other through the first via hole may become the second node.

The connection pattern formed may be positioned in a pixel area. The connection pattern may partially overlap the pixel circuit. Furthermore, the connection pattern may partially overlap signal lines. For example, the connection pattern may partially overlap the initialization power line and the data lines. The connection pattern may partially overlap the storage capacitor.

According to some embodiments, the connection pattern may have a shape bypassing the second node at which the first via hole is positioned. For example, the connection pattern may have a shape including an opening area corresponding to the first via hole positioned at the second node.

Embodiments can provide a display device, comprising: a substrate; a transistor on the substrate; a conductive pattern on the transistor, and electrically connected to the transistor; a first insulating layer on the conductive pattern; a connection pattern on the first insulating layer; a second insulating layer on the connection pattern; a light emitting element including a first electrode on the second insulating layer, an emission layer on the first electrode, and a second electrode on the emission layer; and a dummy electrode on the second insulating layer, and spaced apart from the first electrode, wherein the first electrode is electrically connected to the conductive pattern through a first via hole passing through the first and the second insulating layers, wherein the dummy electrode is electrically connected to the connection pattern through a second via hole passing through the second insulating layer, and wherein the first via hole and the second via hole do not overlap each other.

According to some embodiments, no conductive layer (or conductive pattern) other than a first electrode (anode electrode or pixel electrode) of a light emitting element may be located on a conductive pattern positioned at a second node (e.g., a connection point at which a pixel circuit and the light emitting element are electrically connected to each other) of each sub-pixel. Hence, the conductive pattern and the first electrode may be directly electrically connected to each other through a via hole that sequentially passes through a plurality of insulating layers located between the conductive pattern and the first electrode. As a result, the number of masks can be relatively reduced, whereby the fabrication efficiency of a display device may be relatively improved.

Furthermore, a connection pattern that is positioned between the conductive pattern and the first electrode and does not overlap the second node may be electrically connected to a second electrode (or cathode electrode) of the light emitting element, thus preventing or reducing instances of a voltage drop of the second electrode, whereby the display device having relatively improved reliability may be provided.

The effects of the present disclosure are not limited by the foregoing, and other various effects are anticipated herein.

While aspects of some embodiments have been described above, those skilled in the art will appreciate that various modifications, additions and substitutions are possible, without departing from the scope of embodiments according to the present disclosure.

Therefore, the embodiments disclosed in this specification are only for illustrative purposes rather than limiting the technical scope of the present disclosure. The scope of embodiments according to the present disclosure are defined by the accompanying claims, and their equivalents.

## Claims

1. A display device, comprising:
a substrate;
a first conductive layer, a second conductive layer, a third conductive layer, a fourth conductive layer, and a fifth conductive layer sequentially stacked on the substrate;
a transistor on the substrate;
a conductive pattern on the transistor, and electrically connected to the transistor, and comprising the third conductive layer;
an insulating layer on the conductive pattern and including a first via hole exposing one area of the conductive pattern;
a light emitting element on the insulating layer, and electrically connected to the conductive pattern through the first via hole; and
a connection pattern arranged between the conductive pattern and the light emitting element, and comprising the fourth conductive layer,
wherein the connection pattern does not overlap the first via hole.

2. The display device according to claim 1,
wherein the insulating layer includes a first passivation layer, a first via layer, a second passivation layer, and a second via layer that are sequentially on the conductive pattern,
wherein the connection pattern is arranged between the first via layer and the second passivation layer, and
wherein the light emitting element is electrically connected to the conductive pattern through the first via hole of each of the first passivation layer, the first via layer, the second passivation layer, and the second via layer.

3. The display device according to claim 2, wherein the connection pattern includes an opening area corresponding to the first via hole.

4. The display device according to claim 3,
wherein the connection pattern includes a first connection pattern extending in a first direction, and a second connection pattern extending in a second direction intersecting with the first direction, and
wherein the first connection pattern and the second connection pattern form a mesh structure.

5. The display device according to any one of claims 2 to 4,
wherein the light emitting element comprises:
a first electrode on the connection pattern, and electrically connected to the conductive pattern through the first via hole, and comprising the fifth conductive layer;
an emission layer on the first electrode; and
a second electrode on the emission layer,
wherein the connection pattern is electrically connected with the second electrode.

6. The display device according to claim 5, wherein in a sectional view, the first electrode is on the conductive pattern with the first via hole interposed therebetween, and the fourth conductive layer is not between the conductive pattern and the first electrode.

7. The display device according to claim 6, further comprising a dummy electrode comprising the fifth conductive layer, and spaced apart from the first electrode,
wherein the dummy electrode is electrically connected to the connection pattern.

8. The display device according to claim 7,
wherein each of the second passivation layer and the second via layer includes a second via hole exposing a portion of the connection pattern, and
wherein the dummy electrode is electrically connected to the connection pattern through the second via hole.

9. The display device according to claim 7 or 8,
wherein the dummy electrode includes a first dummy electrode extending in a first direction, and a second dummy electrode extending in a second direction intersecting with the first direction, andwherein the first dummy electrode and the second dummy electrode form a mesh structure; or
wherein the dummy electrode includes a first dummy electrode extending in a first direction, and a second dummy electrode extending in a second direction intersecting with the first direction, and wherein the first dummy electrode and the second dummy electrode are spaced apart from each other.

10. The display device according to any one of claims 7 to 9, further comprising a pixel defining layer on the first electrode, and including a first opening corresponding to the emission layer, and a second opening exposing one area of the dummy electrode,
wherein the second electrode is electrically connected to the dummy electrode through the second opening.

11. The display device according to any one of claims 6 to 9, further comprising a pixel defining layer on the first electrode, and including a first opening corresponding to the emission layer, and a second opening exposing one area of the second via layer,
wherein each of the second passivation layer and the second via layer includes a third via hole exposing one area of the connection pattern, and
wherein the second electrode is electrically connected to the connection pattern through the second opening and the third via hole;
optionally wherein the second opening and the third via hole overlap each other, in a plan view;
optionally further comprising a dummy electrode comprising the fifth conductive layer, and spaced apart from the first electrode, wherein the dummy electrode is not electrically connected to the connection pattern and the second electrode.

12. The display device according to any one of claims 1 to 11, further comprising an encapsulation layer on the light emitting element.

13. A display device, comprising:
a substrate;
a transistor on the substrate;
a conductive pattern on the transistor, and electrically connected to the transistor;
a first insulating layer on the conductive pattern;
a connection pattern on the first insulating layer;
a second insulating layer on the connection pattern;
a light emitting element including a first electrode on the second insulating layer, an emission layer on the first electrode, and a second electrode on the emission layer; and
a dummy electrode on the second insulating layer, and spaced apart from the first electrode,
wherein the first electrode is electrically connected to the conductive pattern through a first via hole passing through the first and the second insulating layers,
wherein the dummy electrode is electrically connected to the connection pattern through a second via hole passing through the second insulating layer, and
wherein the first via hole and the second via hole do not overlap each other.

14. The display device according to claim 13, wherein the connection pattern does not overlap the first via hole;
optionally wherein the connection pattern includes an opening area corresponding to the first via hole.

15. The display device according to claim 13 or 14,
wherein the connection pattern includes a first connection pattern extending in a first direction, and a second connection pattern extending in a second direction intersecting with the first direction, and wherein the first connection pattern and the second connection pattern form a mesh structure; and/or
wherein the dummy electrode includes a first dummy electrode extending in a first direction, and a second dummy electrode extending in a second direction intersecting with the first direction, and wherein the first dummy electrode and the second dummy electrode form a mesh structure.
